# EUROPEAN PATENT APPLICATION

(11) **EP 4 565 048 A1**
(43) Date of publication of application: **04.06.2025**
(21) Application number: 24214901.1
(22) Date of filing: 22.11.2024
(51) Int. Cl.: H10K 59/80

(54) **DISPLAY PANEL AND METHOD OF MANUFACTURING THE SAME**

(30) Priority: 28.11.2023 KR 20230168516
(71) Applicant: Samsung Display Co., Ltd., Gyeonggi-Do (KR)
(72) Inventor: YANG, Hee Jun, Yongin-si (KR); SONG, Seungyong, Yongin-si (KR)
(74) Representative: Marks & Clerk LLP

(57) **Abstract**

A display panel includes: a base layer; a pixel defining film disposed on the base layer and defining a light emitting opening therein; a partition wall disposed on the pixel defining film and defining a partition wall opening therein overlapping the light emitting opening in a plan view; a plurality of light emitting elements each including an anode, a light emitting pattern, and a cathode and arranged inside the light emitting opening and the partition wall opening, where the cathode is in contact with the partition wall; a plurality of lower encapsulation inorganic patterns that cover the plurality of light emitting elements, respectively; and a common inorganic film that covers the plurality of lower encapsulation inorganic patterns and fills spaces between the partition wall and the plurality of lower encapsulation inorganic patterns.

## Description

### BACKGROUND

Embodiments of the present disclosure relate to a display panel and a method of manufacturing a display panel, and more particularly, a display panel having improved display quality.

Display devices such as televisions, monitors, smart phones, and tablet personal computers (PCs) that provide images to users include display panels that display images. Various display panels such as liquid crystal display panels, organic light emitting display panels, electro wetting display panels, and electrophoretic display panels have been developed as the display panels.

The organic light emitting display panel may include an anode, a cathode, and a light emitting pattern. The light emitting pattern may be separated for each of light emitting areas, and the cathode may provide a common voltage to each of the light emitting areas.

### SUMMARY

Embodiments of the present disclosure provide a display panel forming a light emitting element without using a metal mask and having improved display quality, and a method of manufacturing the same.

According to an embodiment, a display panel includes: a base layer; a pixel defining film disposed on the base layer and defining a light emitting opening therein; a partition wall disposed on the pixel defining film and defining a partition wall opening therein overlapping the light emitting opening in a plan view; a plurality of light emitting elements each including an anode, a light emitting pattern, and a cathode and arranged inside the light emitting opening and the partition wall opening, where the cathode is in contact with the partition wall; a plurality of lower encapsulation inorganic patterns that cover the plurality of light emitting elements, respectively; and a common inorganic film that covers the plurality of lower encapsulation inorganic patterns and fills spaces between the partition wall and the plurality of lower encapsulation inorganic patterns.

The plurality of light emitting elements may include first light emitting elements, second light emitting elements, and third light emitting elements that emit different color lights, and the plurality of lower encapsulation inorganic patterns may include first lower encapsulation inorganic patterns that cover the first light emitting elements, second lower encapsulation inorganic patterns that cover the second light emitting elements, and third lower encapsulation inorganic patterns that cover the third light emitting elements.

The common inorganic film may cover the first to third lower encapsulation inorganic patterns, which are dried.

The display panel may further include first additional encapsulation inorganic patterns that cover the dried first lower encapsulation inorganic patterns, second additional encapsulation inorganic patterns that cover the dried second lower encapsulation inorganic patterns, and third additional encapsulation inorganic patterns that cover the dried third lower encapsulation inorganic patterns.

The common inorganic film may cover the first to third additional encapsulation inorganic patterns.

An inner area may be defined in the common inorganic film, and the inner area may be empty space.

The inner area may have a shape surrounding the light emitting opening in the plan view.

A portion of the inner area may overlap the plurality of lower encapsulation inorganic patterns in the plan view.

Each of the plurality of lower encapsulation inorganic patterns may include an upper surface, first side surfaces extending from the upper surface in a thickness direction of the base layer, lower surfaces extending from the first side surfaces toward a center of the anode in the cross-sectional view, and second side surfaces extending from the lower surfaces in the thickness direction of the base layer.

The common inorganic film may cover the upper surface, the first side surfaces, the lower surfaces, and the second side surfaces of each of the plurality of lower encapsulation inorganic patterns, which are dried.

The common inorganic film may include an inorganic material.

The common inorganic film may include at least one of a silicon nitride (SiNₓ) and a silicon oxy nitride (SiON).

The display panel may further include an encapsulation organic film that covers the common inorganic film, and an upper encapsulation inorganic film that covers the encapsulation organic film.

According to an embodiment, a method of manufacturing a display panel includes: providing a preliminary display panel including a base layer, a pixel defining film disposed on the base layer, and a preliminary partition wall disposed on the pixel defining film; forming a partition wall defining a partition wall opening therein from the preliminary partition wall; etching the pixel defining film to form a light emitting opening overlapping the partition wall opening in a plan view; forming a light emitting element and a lower encapsulation inorganic pattern that covers the light emitting element inside the light emitting opening and the partition wall opening; and drying outer surfaces of the partition wall and the lower encapsulation inorganic pattern.

The forming of the light emitting element and the lower encapsulation inorganic pattern may include: forming a first light emitting element and a first lower encapsulation inorganic pattern that covers the first light emitting element, forming a second light emitting element and a second lower encapsulation inorganic pattern that covers the second light emitting element, and forming a third light emitting element and a third lower encapsulation inorganic pattern that covers the third light emitting element.

The method may further include: forming a common inorganic film that covers the first to third lower encapsulation inorganic patterns.

The method may further include: forming an additional encapsulation inorganic pattern that covers the lower encapsulation inorganic pattern.

The drying of the outer surfaces of the partition wall and the lower encapsulation inorganic pattern may include: drying the outer surface of the partition wall and an outer surface of the first lower encapsulation inorganic pattern after the forming of the first light emitting element and the first lower encapsulation inorganic pattern; drying the outer surface of the partition wall and an outer surface of the second lower encapsulation inorganic pattern after the forming of the second light emitting element and the second lower encapsulation inorganic pattern; and drying the outer surface of the partition wall and an outer surface of the third lower encapsulation inorganic pattern after the forming of the third light emitting element and the third lower encapsulation inorganic pattern, and the forming of the additional encapsulation inorganic pattern that covers the lower encapsulation inorganic pattern may include: forming a first additional encapsulation inorganic pattern that covers the first lower encapsulation inorganic pattern; forming a second additional encapsulation inorganic pattern that covers the second lower encapsulation inorganic pattern; and forming a third additional encapsulation inorganic pattern that covers the third lower encapsulation inorganic pattern.

The method may further include forming a common inorganic film that covers the first to third additional encapsulation inorganic patterns.

According to an embodiment, a display panel includes: a base layer; a pixel defining film disposed on the base layer and defining a light emitting opening therein; a partition wall disposed on the pixel defining film and defining a partition wall opening therein overlapping the light emitting opening in a plan view; a plurality of light emitting elements each including an anode, a light emitting pattern, and a cathode and arranged inside the light emitting opening and the partition wall opening, where the cathode is in contact with the partition wall; and a plurality of lower encapsulation inorganic patterns that cover the plurality of light emitting elements, respectively, where only an inorganic material is disposed between the plurality of lower encapsulation inorganic patterns and an upper surface of the partition wall.

At least some of the above and other features of the invention are set out in the claims.

### BRIEF DESCRIPTION OF THE FIGURES

The above and other aspects and features of the present disclosure will become apparent by describing in detail embodiments thereof with reference to the accompanying drawings.
FIG. 1A is a perspective view of a display device according to an embodiment of the present disclosure.
FIG. 1B is an exploded perspective view of the display device according to an embodiment of the present disclosure.
FIG. 2 is a cross-sectional view of a display module according to an embodiment of the present disclosure.
FIG. 3 is a plan view of a display panel according to an embodiment of the present disclosure.
FIG. 4 is an enlarged plan view of a portion of a display area of the display panel according to an embodiment of the present disclosure.
FIG. 5 is a cross-sectional view along line I-I' of FIG. 3.
FIG. 6 is a cross-sectional view along line II-II' of FIG. 4.
FIGS. 7A to 7I and 8A to 8E are cross-sectional views illustrating some of operations of a method of manufacturing a display panel according to an embodiment of the present disclosure.
FIG. 9 is a cross-sectional view along line II-II' of FIG. 4.

### DETAILED DESCRIPTION

In the specification, the expression that a first component (or area, layer, part, portion, etc.) is "on", "connected with", or "coupled to" a second component means that the first component is directly on, connected with, or coupled to the second component or means that a third component is disposed therebetween.

The same reference numerals refer to the same components. Further, in the drawings, the thickness, the ratio, and the dimension of components are exaggerated for effective description of technical contents. The expression "and/or" includes one or more combinations which associated components are capable of defining.

Although the terms "first", "second", etc. may be used to describe various components, the components should not be limited by the terms. The terms are only used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Unless otherwise defined, all terms (including technical terms and scientific terms) used in this specification have the same meaning as commonly understood by those skilled in the art to which the present disclosure belongs. Furthermore, terms such as terms defined in the dictionaries commonly used should be interpreted as having a meaning consistent with the meaning in the context of the related technology, and should not be interpreted in overly ideal or formal meanings unless explicitly defined herein.

Throughout the disclosure, the expression "at least one of a, b and c" indicates only a, only b, only c, both a and b, both a and c, both b and c, all of a, b, and c, or variations thereof. Hereinafter, embodiments of the present disclosure will be described with reference to the accompanying drawings.

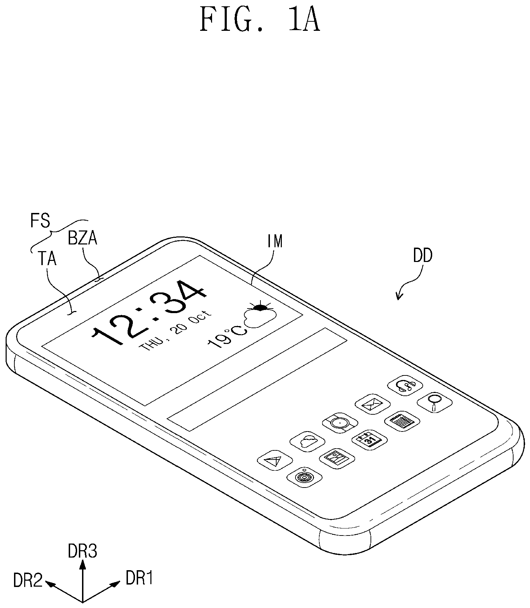

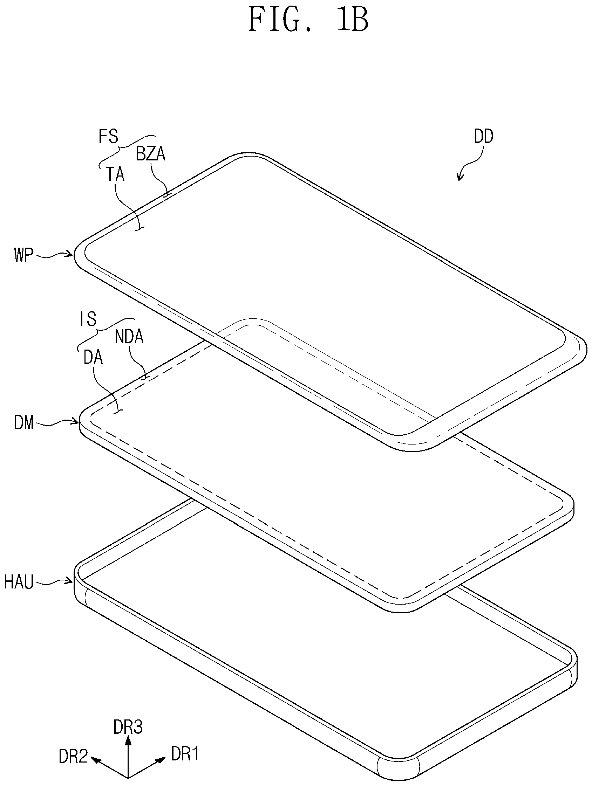

FIG. 1A is a perspective view of a display device DD according to an embodiment of the present disclosure, and FIG. 1B is an exploded perspective view of the display device DD according to an embodiment of the present disclosure.

In an embodiment, the display device DD may be a large electronic device such as a television, a monitor, or an external billboard. Further, the display device DD may be a small or medium-sized electronic device such as a personal computer (PC) (e.g., a laptop or a table PC), a personal digital terminal, a vehicle navigation unit, a game console, a smart phone, and a camera. However, this is illustrative, and other display devices may be adopted as long as the display devices do not deviate from the concept of the present disclosure. FIGS. 1A and 1B illustratively illustrate that the display device DD is a smart phone.

Referring to FIGS. 1A and 1B, the display device DD may display an image IM in a third direction DR3 on a display surface FS parallel to a first direction DR1 and a second direction DR2. The image IM may include a still image as well as a dynamic image. In FIG. 1A, a watch window and icons are illustrated as an example of the image IM. The display surface FS on which the image IM is displayed may correspond to a front surface of the display device DD.

In an embodiment, a front surface (or an upper surface) and a rear surface (or a lower surface) of each member are defined with respect to a direction, in which the image IM is displayed. The front surface and the rear surface may face each other in the third direction DR3, and a normal direction of each of the front and rear surfaces may be parallel to the third direction DR3. Meanwhile, directions indicated by the first to third directions DR1, DR2, and DR3 are relative concepts and may be changed to other directions. In the specification, a phrase of "on a plane" may mean a state when viewed in the third direction DR3 (i.e., plan view).

The display device DD may include a window WP, a display module DM, and a housing HAU. The window WP and the housing HAU may be coupled to each other to constitute an exterior of the display device DD.

The window WP may include an optically transparent insulating material. For example, the window WP may include a glass or plastic. A front surface of the window WP may define the display surface FS of the display device DD. The display surface FS may include a transmissive area TA and a bezel area BZA. The transmissive area TA may be an optically transparent area. For example, the transmissive area TA may be an area having a visible light transmittance of about 90% or more.

The bezel area BZA may be an area having a relatively lower light transmittance than the light transmittance of the transmissive area TA. The bezel area BZA may define a shape of the transmissive area TA. The bezel area BZA may be adjacent to the transmissive area TA and surround the transmissive area TA. However, this is illustrative, and the bezel area BZA of the window WP may be omitted. The window WP may include at least one functional layer of a fingerprint preventing layer, a hard coating layer, and a reflection preventing layer, and is not limited to an embodiment.

The display module DM may be disposed under the window WP. The display module DM may be a component that substantially generates the image IM. The image IM generated by the display module DM is displayed on a display surface IS of the display module DM and is visually recognized by a user from the outside through the transmissive area TA.

The display module DM may include a display area DA and a non-display area NDA. The display area DA may be an area that is activated according to an electric signal. The non-display area NDA may be adjacent to the display area DA. The non-display area NDA may surround the display area DA. The non-display area NDA is an area covered by the bezel area BZA and may not be visually recognized from the outside.

The housing HAU may be coupled to the window WP. The housing HAU may be coupled to the window WP to provide a predetermined inner space. The display module DM may be accommodated in the inner space.

The housing HAU may include a material having a relatively high rigidity. For example, the housing HAU may include a plurality of frames and/or plates including a glass, a plastic, or a metal or made of a combination thereof. The housing HAU may stably protect components of the display device DD accommodated in the inner space from an external impact.

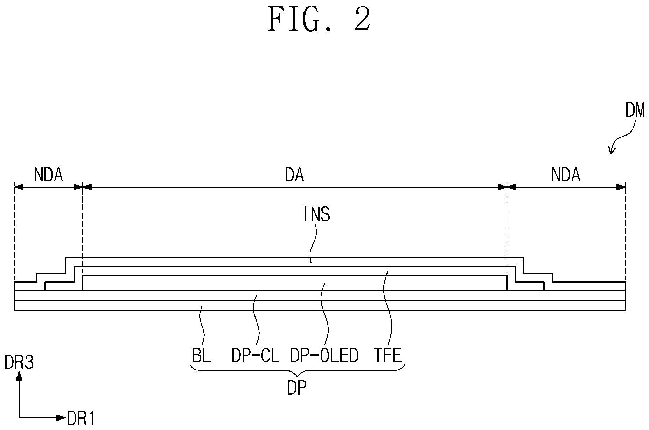

FIG. 2 is a cross-sectional view of the display module DM according to an embodiment of the present disclosure.

Referring to FIG. 2, the display module DM may include a display panel DP and an input sensor INS. Although not separately illustrated, the display device DD (see FIG. 1A) according to an embodiment of the present disclosure may further include a protective member disposed on a lower surface of the display panel DP and a reflection preventing member and/or a window member disposed on an upper surface of an input sensor INS.

The display panel DP may be a light emitting display panel. However, this is illustrative, and the present disclosure is not particularly limited thereto. For example, the display panel DP may be an organic light emitting display panel or an inorganic light emitting display panel. A light emitting layer in the organic light emitting display panel may include an organic light emitting material. A light emitting layer in the inorganic light emitting display panel may include a quantum dot, a quantum rod, or a micro light emitting diode (LED). Hereinafter, the display panel DP will be described as the organic light emitting display panel.

The display panel DP may include a base layer BL and a circuit element layer DP-CL, a display element layer DP-OLED, and a thin film encapsulation layer TFE which are arranged on the base layer BL. The input sensor INS may be directly disposed on the thin film encapsulation layer TFE. In the specification, the wording "component A is directly disposed on component B" means that no adhesive layer is disposed between component A and component B.

The base layer BL may include at least one plastic film. The base layer BL is a flexible substrate and may include a plastic substrate, a glass substrate, a metal substrate, or an organic/inorganic composite material substrate. The display area DA and the non-display area NDA described in FIG. 1B may be equally defined on the base layer BL.

The circuit element layer DP-CL may include at least one insulating layer and a circuit element. The insulating layer includes at least one inorganic layer and at least one organic layer. The circuit element includes signal lines, a driving circuit of a pixel, and/or the like.

The display element layer DP-OLED may include a partition wall and a light emitting element. The light emitting element may include an anode, an intermediate layer, and a cathode.

The thin film encapsulation layer TFE may include a plurality of thin films. Some thin films may be arranged to improve optical efficiency, and some thin films may be arranged to protect organic light emitting diodes.

The input sensor INS acquires coordinate information of an external input. The input sensor INS may have a multilayer structure. The input sensor INS may include a single-layered or multi-layered conductive layer. Further, the input sensor INS may include a single-layered or multi-layered insulating layer. The input sensor INS may sense an external input in a capacitive manner. However, this is illustrative, and the present disclosure is not limited thereto. For another example, in an embodiment, the input sensor INS may also sense an external input in an electromagnetic induction manner or a pressure sensing manner. Meanwhile, in an embodiment of the present disclosure, the input sensor INS may be omitted.

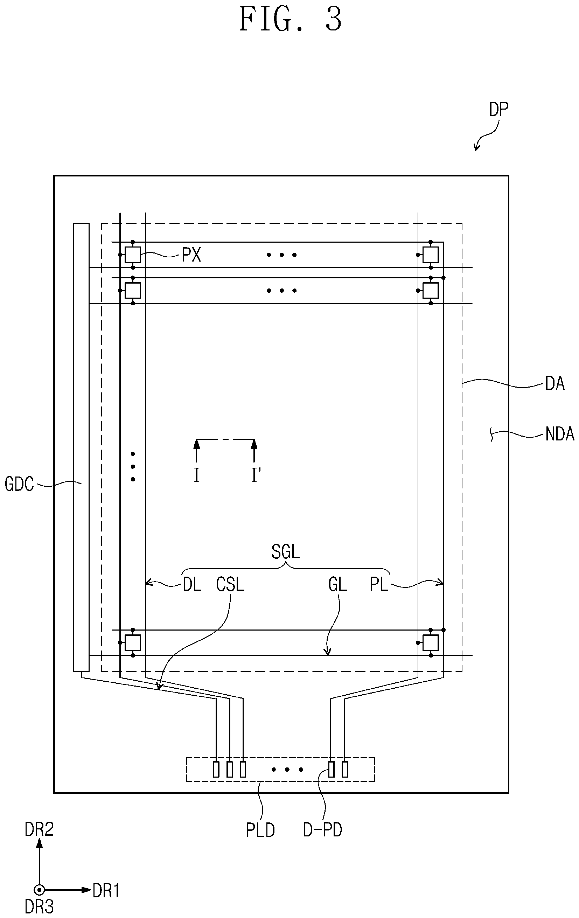

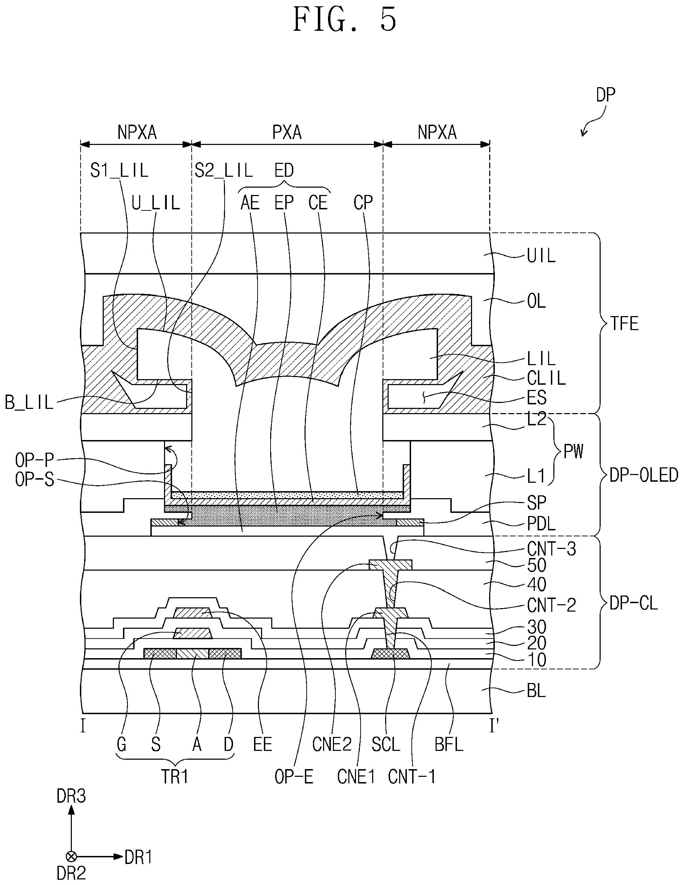

FIG. 3 is a plan view of a display panel DP according to an embodiment of the present disclosure. As used herein, the "plan view" is a view in a thickness direction (i.e., the third direction DR3) of a base layer BL (See FIG 5).

Referring to FIG. 3, the display area DA and the non-display area NDA around the display area DA may be defined in the display panel DP. The display panel DP may include pixels PX and signal lines SGL electrically connected to the pixels PX. The display panel DP may include a driving circuit GDC and a pad part PLD. The display area DA and the non-display area NDA may be distinguished depending on whether the pixel PX is disposed. The pixel PX may be disposed in the display area DA. The driving circuit GDC and the pad partPLD may be arranged in the non-display area NDA.

The pixels PX may be arranged in the first direction DR1 and the second direction DR2. The pixels PX may include a plurality of pixel rows extending in the first direction DR1 and arranged in the second direction DR2 and a plurality of pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signal to the gate lines GL. The gate driving circuit may further output another control signal to a pixel driving circuit.

The pad part PLD may be a portion to which a flexible circuit board is connected. The pad part PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to the corresponding pixels PX through the signal lines SGL. Further, any one pixel pad among the pixel pads D-PD may be connected to the driving circuit GDC.

Further, the pad part PLD may further include input pads. The input pads may be pads for connecting the flexible circuit board to the input sensor INS (see FIG. 2). However, the present disclosure is not limited thereto, and the input pads may be arranged in the input sensor INS (see FIG. 2) and connected to the pixel pads D-PD and a separate circuit board in another embodiment. Alternatively, the input sensor INS (see FIG. 2) may be omitted and may not further include the input pads.

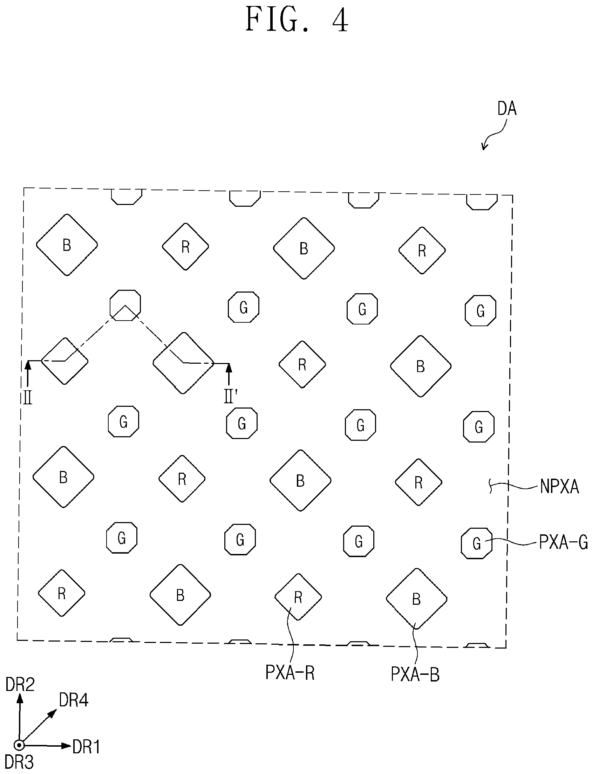

FIG. 4 is an enlarged plan view of a portion of the display area DA of the display panel DP (see FIG. 2) according to an embodiment of the present disclosure. FIG. 4 illustrates a plan view of the display module DM when viewed from the display surface IS (see FIG. 1B) of the display module DM (see FIG. 1B) and illustrates arrangement of light emitting areas PXA-R, PXA-G, and PXA-B.

Referring to FIG. 4, the display area DA may include the first to third light emitting areas PXA-R, PXA-G, and PXA-B and a peripheral area NPXA surrounding the first to third light emitting areas PXA-R, PXA-G, and PXA-B. The first to third light emitting areas PXA-R, PXA-G, and PXA-B may correspond to areas from which lights provided from the light emitting elements are emitted, respectively. The first to third light emitting areas PXA-R, PXA-G, and PXA-B may be distinguished according to a color of a light emitted toward the outside of the display module DM (see FIG. 2).

The first to third light emitting areas PXA-R, PXA-G, and PXA-B may provide first to third color lights having different colors, respectively. For example, the first color light may be a red light, the second color light may be a green light, and the third color light may be a blue light. However, examples of the first to third color lights are not necessarily limited to the above example.

Each of the first to third light emitting areas PXA-R, PXA-G, and PXA-B may be defined as an area in which an upper surface of the anode is exposed by a light emitting opening, which will be described below. The peripheral area NPXA may set boundaries between the first to third light emitting areas PXA-R, PXA-G, and PXA-B and prevent color mixing between the first to third light emitting areas PXA-R, PXA-G, and PXA-B.

The first to third light emitting areas PXA-R, PXA-G, and PXA-B may be provided such that all of the numbers thereof are plural and may be repeatedly arranged in the display area DA in a specific arrangement form. For example, the first and third light emitting areas PXA-R and PXA-B may be alternately arranged in the first direction DR1 to constitute a "first group." The second light emitting areas PXA-G may arranged in the first direction DR1 to constitute a "second group." Each of the "first group" and the "second group" may be provided in plurality, and the "first groups" and the "second groups" may be alternately arranged in the second direction DR2.

One second light emitting area PXA-G may be spaced apart from one first light emitting area PXA-R or one third light emitting area PXA-B in a fourth direction DR4. The fourth direction DR4 may be defined as a direction between the first and second directions DR1 and DR2.

Meanwhile, FIG. 4 illustratively illustrates an arrangement form of the first to third light emitting areas PXA-R, PXA-G, and PXA-B, but the present disclosure is not limited thereto, and the first to third light emitting areas PXA-R, PXA-G, and PXA-B may be arranged in various forms. In an embodiment, as illustrated in FIG. 4, the first to third light emitting areas PXA-R, PXA-G, and PXA-B may have a PENTILE arrangement form. Alternatively, the first to third light emitting areas PXA-R, PXA-G, and PXA-B may also have a stripe arrangement form or a diamond pixel arrangement form.

The first to third light emitting areas PXA-R, PXA-G, and PXA-B may have various shapes on a plane. For example, the first to third light emitting areas PXA-R, PXA-G, and PXA-B may have shapes such as a polygonal shape, a circular shape, or an elliptic shape. FIG. 4 illustratively illustrates the first and third light emitting areas PXA-R and PXA-B having a quadrangular shape (or a diamond shape) and the second light emitting area PXA-G having an octagonal shape on a plane.

The first to third light emitting areas PXA-R, PXA-G, and PXA-B may have the same shape on a plane or may have at least partially different shapes. FIG. 4 illustratively illustrates the first and third light emitting areas PXA-R and PXA-B having the same shape and the second light emitting area PXA-G having a shape different from a shape of the first and third light emitting areas PXA-R and PXA-B on a plane.

At least some of the first to third light emitting areas PXA-R, PXA-G, and PXA-B may have different areas on a plane. In an embodiment, an area of the first light emitting area PXA-R that emits a red light may be greater than an area of the second light emitting area PXA-G that emits a green light and may be smaller than an area of the third light emitting area PXA-B that emits a blue light. However, a size relationship between the areas of the first to third light emitting areas PXA-R, PXA-G, and PXA-B according to the color of the emitted light is not limited thereto and may be varied depending on a design of the display module DM (see FIG. 2). Further, the present disclosure is not limited thereto, and the first to third light emitting areas PXA-R, PXA-G, and PXA-B may also have the same area on a plane in another embodiment.

The shape, the area, the arrangement, and/or the like of the first to third light emitting areas PXA-R, PXA-G, and PXA-B of the display module DM (see FIG. 2) of the present disclosure may be variously designed according to the color of the emitted light or the size and configuration of the display module DM (see FIG. 2) and are not limited to an embodiment illustrated in FIG. 4.

FIG. 5 is a cross-sectional view of the display panel DP along line I-I' of FIG. 3. In description of FIG. 5, the description will be made with reference to FIG. 2, and descriptions for the same reference numerals will be omitted. FIG. 5 enlargedly illustrates one light emitting area PXA in the display area DA (see FIG. 4), and the light emitting area PXA of FIG. 5 may correspond to one of the first to third light emitting areas PXA-R, PXA-G, and PXA-B of FIG. 4.

Referring to FIG. 5, the display panel DP may include the base layer BL, the circuit element layer DP-CL, the display element layer DP-OLED, and the thin film encapsulation layer TFE.

The display panel DP may include a plurality of insulating layers, a plurality of semiconductor patterns, a plurality of conductive patterns, a plurality of signal lines, and/or the like. The insulating layer, the semiconductor layer, and the conductive layer are formed by coating, deposition, or the like. Thereafter, the insulating layer, the semiconductor layer, and the conductive layer may be selectively patterned by photolithography and etching. In this manner, the semiconductor pattern, the conductive pattern, the signal line, and/or the like included in the circuit element layer DP-CL and the display element layer DP-OLED may be formed.

The circuit element layer DP-CL may be disposed on the base layer BL. The circuit element layer DP-CL may include a buffer layer BFL, a transistor TR1, a signal transmitting area SCL, first to fifth insulating layers 10, 20, 30, 40, and 50, an electrode EE, and a plurality of connection electrodes CNE1 and CNE2.

The buffer layer BFL may be disposed on the base layer BL. The buffer layer BFL may improve a coupling force between the base layer BL and the semiconductor pattern. The buffer layer BFL may include a silicon oxide layer and a silicon nitride layer. The silicon oxide layer and the silicon nitride layer may be alternately laminated.

The semiconductor pattern may be disposed on the buffer layer BFL. The semiconductor pattern may include polysilicon. However, the present disclosure is not limited thereto, and the semiconductor pattern may include amorphous silicon or metal oxide in another embodiment. FIG. 5 illustratively illustrates a portion of the semiconductor pattern, and the semiconductor patterns may be further arranged in the plurality of light emitting areas PXA-R, PXA-G, and PXA-B (see FIG. 4). The semiconductor pattern may be arranged in a specific rule across the plurality of light emitting areas PXA-R, PXA-G, and PXA-B. The semiconductor pattern may have a different electrical property depending on whether or not the semiconductor pattern is doped. The semiconductor pattern may include a first area having a high doping concentration and a second area having a low doping concentration. The first area may be doped with an N-type dopant or a P-type dopant. A P-type transistor may include the first area doped with the P-type dopant.

A conductivity of the first area is greater than a conductivity of the second area, and the first area may substantially serve as an electrode or a signal line. The second area may substantially correspond to an active (or a channel) of a transistor. In other words, a portion of the semiconductor pattern may be the active of the transistor, another portion of the semiconductor pattern may be a source or a drain of the transistor, and still another portion of the semiconductor pattern may be a conductive area.

A source "S," an active "A," and a drain "D" of the transistor TR1 may be formed from the semiconductor pattern. FIG. 5 illustrates a portion of the signal transmitting area SCL formed from the semiconductor pattern. Although not separately illustrated, the signal transmitting area SCL may be connected to the drain "D" of the transistor TR1 on a plane.

The first to fifth insulating layers 10, 20, 30, 40, and 50 may be arranged on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source "S," the active "A," and the drain "D" of the transistor TR1 disposed on the buffer layer BFL, and the signal transmitting area SCL. A gate "G" of the transistor TR1 may be disposed on the first insulating layer 10. The second insulating layer 20 may be disposed on the first insulating layer 10 to cover the gate "G." The electrode EE may be disposed on the second insulating layer 20. The third insulating layer 30 may be disposed on the second insulating layer 20 to cover the electrode EE.

The first connection electrode CNE1 may be disposed on the third insulating layer 30. The first connection electrode CNE1 may be connected to the signal transmitting area SCL through a contact hole CNT-1 passing through the first to third insulating layers 10, 20, and 30. The fourth insulating layer 40 may be disposed on the third insulating layer 30 to cover the first connection electrode CNE1. The fourth insulating layer 40 may be an organic layer.

The second connection electrode CNE2 may be disposed on the fourth insulating layer 40. The second connection electrode CNE2 may be connected to the first connection electrode CNE1 through a contact hole CNT-2 passing through the fourth insulating layer 40. The fifth insulating layer 50 may be disposed on the fourth insulating layer 40 to cover the second connection electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining film PDL, and a partition wall PW.

The light emitting element ED may include an anode AE (or a first electrode), a light emitting pattern EP, and a cathode CE (or a second electrode). The light emitting element ED may be disposed in a light emitting opening OP-E and a partition wall opening OP-P, which will be described below.

The anode AE may be disposed on the fifth insulating layer 50 of the circuit element layer DP-CL. The anode AE may be a transmissive electrode, a semi-transmissive electrode, or a reflective electrode. The anode AE may be connected to the second connection electrode CNE2 through a connection contact hole CNT-3 defined through the fifth insulating layer 50. Thus, the anode AE may be electrically connected to the signal transmitting area SCL through the first and second connection electrodes CNE1 and CNE2 and thus electrically connected to the corresponding circuit element. The anode AE may include a single-layer structure or a multi-layer structure. The anode AE may include a plurality of layers including ITO and Ag. For example, the anode AE may include a layer including the ITO (hereinafter, referred to as a lower ITO layer), a layer disposed on the lower ITO layer and including Ag (hereinafter, referred to as an Ag layer), and a layer disposed on the Ag layer and including the ITO (hereinafter, referred to as an upper ITO layer).

The sacrificial pattern SP may be disposed between the anode AE and the pixel defining film PDL. The sacrificial pattern SP may define (or have) a sacrificial opening OP-S through which a portion of an upper surface of the anode AE is exposed. The sacrificial opening OP-S may overlap the light emitting opening OP-E in a plan view, which will be described below.

The pixel defining film PDL may be disposed on the fifth insulating layer 50 of the circuit element layer DP-CL. The pixel defining film PDL may define (or have) the light emitting opening OP-E. The light emitting opening OP-E may correspond the anode AE, and the pixel defining film PDL may expose at least a portion of the anode AE through the light emitting opening OP-E.

Further, the light emitting opening OP-E may correspond to the sacrificial opening OP-S of the sacrificial pattern SP. According to an embodiment, the upper surface of the anode AE may be spaced apart from the pixel defining film PDL on a cross section with the sacrificial pattern SP interposed therebetween, and accordingly, damage to the anode AE may be protected in a process of forming the light emitting opening OP-E.

On a plane, an area of the light emitting opening OP-E may be smaller than an area of the sacrificial opening OP-S. That is, an inner surface of the pixel defining film PDL defining the light emitting opening OP-E may be closer to a center of the anode AE than an inner surface of the sacrificial pattern SP defining the sacrificial opening OP-S. However, the present disclosure is not limited thereto, and the inner surface of the sacrificial pattern SP defining the sacrificial opening OP-S may be substantially aligned with the inner surface of the pixel defining film PDL defining the light emitting opening OP-E in another embodiment. In this case, the light emitting area PXA may be regarded as an area of the anode AE exposed from the corresponding sacrificial opening OP-S.

The pixel defining film PDL may include an inorganic insulating material. For example, the pixel defining film PDL may include a silicon nitride (SiNₓ or silicon nitride). The pixel defining film PDL may be disposed between the anode AE and the partition wall PW and block electrical connection between the anode AE and the partition wall PW.

The light emitting pattern EP may be disposed on the anode AE. The light emitting pattern EP may include a light emitting layer including a light emitting material. The light emitting pattern EP may further include a hole injection layer (HIL) and a hole transport layer (HTL) arranged between the anode AE and the light emitting layer and may further include an electron transport layer (ETL) and an electron injection layer (EIL) arranged on the light emitting layer. The light emitting pattern EP may be referred to an "organic layer" or an "intermediate layer."

The light emitting pattern EP may be patterned by a tip portion defined by the partition wall PW. A detailed description thereof will be made in a description of the method of manufacturing a display panel. The light emitting pattern EP may be disposed inside the sacrificial opening OP-S and the light emitting opening OP-E. However, this is illustratively illustrated, and the light emitting pattern EP may be disposed inside at least one of the sacrificial opening OP-S, the light emitting opening OP-E, and the partition wall opening OP-P. The light emitting pattern EP may cover a portion of an upper surface of the pixel defining film PDL.

The cathode CE may be disposed on the light emitting pattern EP. The cathode CE may be patterned by the tip portion defined by the partition wall PW. At least a portion of the cathode CE may be disposed in the partition wall opening OP-P. FIG. 5 illustratively illustrates that the cathode CE is disposed inside the light emitting opening OP-E and the partition wall opening OP-P, but the present disclosure is not limited thereto. For another example, the cathode CE may be disposed only inside the partition wall opening OP-P.

The cathode CE may extend along a first inner surface of a first partition wall layer L1, and a distal end of the cathode CE may be in contact with the first partition wall layer L1. FIG. 5 illustratively illustrates that the cathode CE is in contact with the first inner surface of the first partition wall layer L1 and the inner surface of the pixel defining film PDL, but the present disclosure is not limited thereto. For another example, the cathode CE may be formed in contact only with the first inner surface of the first partition wall layer L1.

The cathode CE may be conductive. The cathode CE may be formed of various materials such as a metal, a transparent conductive oxide (TCO), and a conductive polymer material as long as the materials may be conductive. For example, the cathode CE may include silver (Ag), magnesium (Mg), lead (Pb), copper (Cu), or compounds thereof.

In an embodiment of the present disclosure, the display element layer DP-OLED may further include a capping pattern CP. The capping pattern CP may be disposed inside the partition wall opening OP-P and disposed on the cathode CE. The capping pattern CP may be patterned by the tip portion defined by the partition wall PW. In an embodiment, the capping pattern CP may be omitted.

The partition wall PW may be disposed on the pixel defining film PDL. The partition wall opening OP-P may be defined in the partition wall PW. The partition wall opening OP-P may overlap the light emitting opening OP-E in a plan view and expose at least a portion of the anode AE.

The partition wall PW may include a plurality of layers that are sequentially laminated. For example, the partition wall PW may include the first partition wall layer L1 and a second partition wall layer L2. The first partition wall layer L1 may be disposed on the pixel defining film PDL, and the second partition wall layer L2 may be disposed on the first partition wall layer L1. As illustrated in FIG. 5, a thickness of the first partition wall layer L1 may be greater than a thickness of the second partition wall layer L2, but the present disclosure is not limited thereto.

The first partition wall layer L1 and the second partition wall layer L2 may include a conductive material. For example, the conductive material may include a metal, a TCO, or a combination thereof. For example, the metal includes gold (Au), silver (Ag), aluminium (Al), magnesium (Mg), lithium (Li), molybdenum (Mo), titanium (Ti), copper (Cu), or alloys thereof. The TCO may include an indium tin oxide (ITO), an indium zinc oxide (IZO), a zinc oxide, an indium oxide, an indium gallium oxide, an indium gallium zinc oxide (IGZO) or an aluminium zinc oxide.

The partition wall PW may have an undercut shape on a cross section. At least one layer among a plurality of layers of the partition wall PW may be recessed compared to other layers, and accordingly, the partition wall PW may include the tip portion. For example, the first partition wall layer L1 may have an undercut shape with respect to the second partition wall layer L2. The second partition wall layer L2 may protrude further toward the light emitting opening OP-E than the first partition wall layer L1. A portion that protrudes from the first partition wall layer L1 toward the light emitting area PXA may be defined as the tip portion inside the partition wall PW. That is, a second inner surface of the second partition wall layer L2 may be closer to the center of the anode AE than the first inner surface of the first partition wall layer L1.

FIG. 5 illustratively illustrates that each of the first inner surface of the first partition wall layer L1 and the second inner surface of the second partition wall layer L2 is perpendicular to the upper surface of the pixel defining film PDL, but the present disclosure is not limited thereto. For another example, the partition wall PW may have a tapered shape or a reverse tapered shape.

The partition wall PW may receive a driving voltage, and accordingly, the cathode CE may be electrically connected to the partition wall PW and receive the driving voltage.

The thin film encapsulation layer TFE may be disposed on the display element layer DP-OLED. The thin film encapsulation layer TFE may include a lower encapsulation inorganic pattern LIL, a common inorganic film CLIL, an encapsulation organic film OL, and an upper encapsulation inorganic film UIL.

The lower encapsulation inorganic pattern LIL may correspond to (or overlap) the light emitting opening OP-E. The lower encapsulation inorganic pattern LIL may be disposed on the capping pattern CP and cover the light emitting element ED. A portion of the lower encapsulation inorganic pattern LIL may be formed inside the partition wall opening OP-P, and another portion of the lower encapsulation inorganic pattern LIL may be formed on the partition wall PW.

The lower encapsulation inorganic pattern LIL may include an upper surface U_LIL, first side surfaces S1_LIL, lower surfaces B_LIL, and second side surfaces S2_LIL. The first side surfaces S1_LIL may extend from the upper surface U_LIL in a thickness direction of the base layer BL (e.g., a direction opposite to the third direction DR3). The lower surfaces B_LIL may extend from the first side surfaces S1_LIL toward the center of the anode AE. The second side surfaces S2_LIL may extend from the lower surfaces B_LIL in the thickness direction of the base layer BL (e.g., the direction opposite to the third direction DR3).

The common inorganic film CLIL may cover the lower encapsulation inorganic pattern LIL and fill a space (e.g., space defined by the first side surface S1_LIL, lower surface B_LIL, second side surface S2_LIL and an upper surface of the second partition wall layer L2) between the partition wall PW and the lower encapsulation inorganic pattern LIL. The common inorganic film CLIL may cover the dried lower encapsulation inorganic pattern LIL. For example, the common inorganic film CLEL may cover the lower encapsulation inorganic pattern LIL in a state in which there is no residual moisture because an outer surface of the lower encapsulation inorganic pattern LIL is dried.

An inner area ES may be defined in the common inorganic film CLIL. The inner area ES may be an empty space formed during a process of depositing the common inorganic film CLIL. For example, the inner area ES may be filled with gas. The inner area ES may have a shape that surrounds the light emitting opening OP-E on a plane. A portion of the inner area ES may overlap the lower encapsulation inorganic pattern LIL on a plane, and the inner area ES may overlap the partition wall PW on a plane. That is, the inner area ES may be formed between the lower encapsulation inorganic pattern LIL and the partition wall PW and overlap the lower encapsulation inorganic pattern LIL and the partition wall PW in a plan view.

The common inorganic film CLIL may cover the upper surface U_LIL, the first side surfaces S1_LIL, the lower surfaces B_LIL, and the second side surfaces S2_LIL of the lower encapsulation inorganic pattern LIL. That is, the common inorganic film CLIL may cover the outer surface of the lower encapsulation inorganic pattern LIL and may be formed by surrounding the inner area ES.

The common inorganic film CLIL may include an inorganic material. For example, the common inorganic film CLIL may include at least one of a silicon nitride (SiNₓ) and a silicon oxy nitride (SiON). That is, only inorganic substances may be present between the lower encapsulation inorganic pattern LIL and the upper surface of the partition wall PW.

The encapsulation organic film OL may be disposed on the common inorganic film CLIL. The encapsulation organic film OL may cover the common inorganic film CLIL and provide a flat upper surface. The upper encapsulation inorganic film UIL may be disposed on the encapsulation organic film OL. The lower encapsulation inorganic pattern LIL, the common inorganic film CLIL, and the upper encapsulation inorganic film UIL may protect the display element layer DP-OLED from moisture/oxygen, and the encapsulation organic film OL may protect the display element layer DP-OLED from foreign substances such as dust particles.

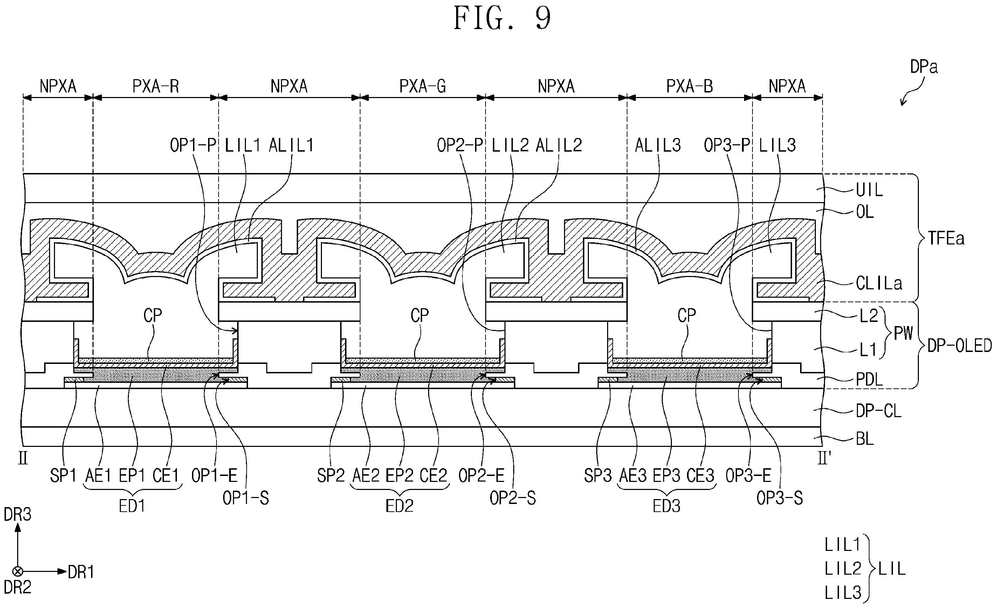

FIG. 5 illustratively illustrates that the thin film encapsulation layer TFE includes the lower encapsulation inorganic pattern LIL, the common inorganic film CLIL, the encapsulation organic film OL, and the upper encapsulation inorganic film UIL, but the present disclosure is not limited thereto. For another example, in an embodiment, the thin film encapsulation layer TFE may further include additional encapsulation inorganic patterns ALIL1, ALIL2, and ALIL3 (see FIG. 9) arranged between the lower encapsulation inorganic pattern LIL and the common inorganic film CLIL. A detailed description will be made below in FIG. 9.

According to the present disclosure, organic substances that absorb moisture between the lower encapsulation inorganic pattern LIL and the partition wall PW may be removed, and residual moisture may be removed through a drying process. Thus, a phenomenon in which foreign substances are introduced through the moisture between the lower encapsulation inorganic pattern LIL and the partition wall PW may be reduced or removed. As a result, pixel defects (dark spots, pixel shrinkage, or the like) of the display panel DP, which are caused by foreign substances, may be effectively reduced or removed.

Further, in the related art, the encapsulation organic film OL is thickened so that the thin film encapsulation layer TFE has a low dielectric constant. However, in the present disclosure, the inner area ES is defined in the common inorganic film CLIL, and thus the common inorganic film CLIL may have a low dielectric constant close to 1. Thus, the thickness of the encapsulation organic film OL of the present disclosure may be reduced, and the thickness of the encapsulation organic film OL may be reduced to effectively improve touch sensitivity.

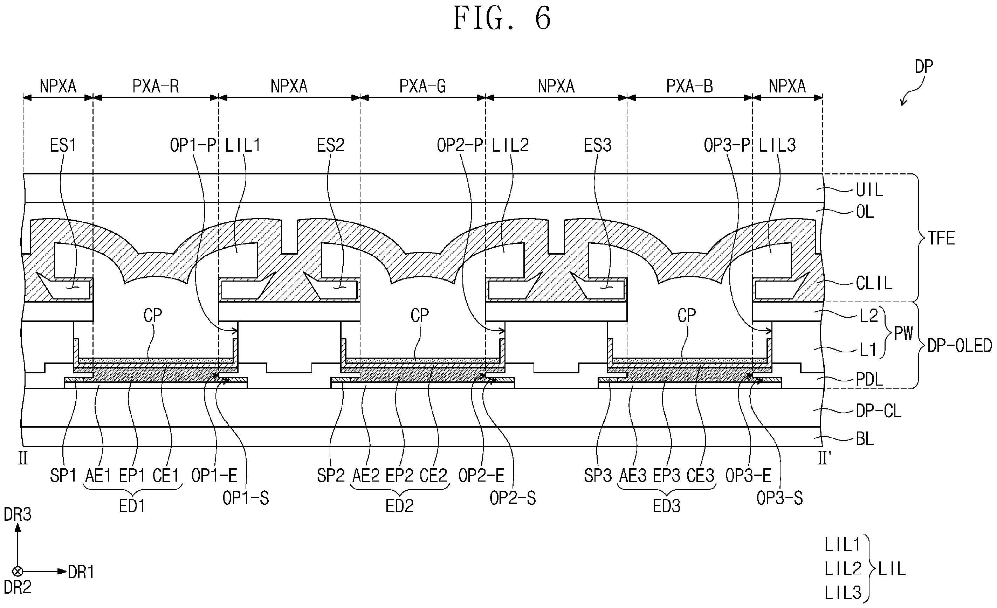

FIG. 6 is a cross-sectional view along line II-II' of FIG. 4. FIG. 6 enlargedly illustrates one first light emitting area PXA-R, one second light emitting area PXA-G, and one third light emitting area PXA-B, and the description of the one light emitting area PXA of FIG. 5 may be equally applied to the first to third light emitting areas PXA-R, PXA-G, and PXA-B of FIG 6. In the description of FIG. 6, the same/similar reference numerals are used for the same/similar components described in FIG. 5, and a duplicated description thereof will be omitted.

Referring to FIG. 6, the display panel DP may include the base layer BL, the circuit element layer DP-CL, the display element layer DP-OLED, and the thin film encapsulation layer TFE. The display element layer DP-OLED may include light emitting elements ED1, ED2, and ED3, sacrificial patterns SP1, SP2, and SP3, the pixel defining film PDL, and the partition wall PW.

The light emitting elements ED1, ED2, and ED3 may include the first light emitting element ED1, the second light emitting element ED2, and the third light emitting element ED3 that emit different color lights. A plurality of first light emitting elements ED1, a plurality of second light emitting elements ED2, and a plurality of third light emitting elements ED3 may be provided. However, for convenience of description, the first light emitting element ED1, the second light emitting element ED2, and the third light emitting element ED3 will be expressed in a singular form below.

The first light emitting element ED1 may include a first anode AE1, a first light emitting pattern EP1, and a first cathode CE1. The second light emitting element ED2 may include a second anode AE2, a second light emitting pattern EP2, and a second cathode CE2. The third light emitting element ED3 may include a third anode AE3, a third light emitting pattern EP3, and a third cathode CE3. The first to third anodes AE1, AE2, and AE3 may be provided as a plurality of patterns. In an embodiment, the first light emitting pattern EP1 may provide red light, the second light emitting pattern EP2 may provide green light, and the third light emitting pattern EP3 may provide blue light.

First to third light emitting openings OP1-E, OP2-E, and OP3-E may be defined in the pixel defining film PDL. The first light emitting opening OP1-E may expose at least a portion of the first anode AE1. The second light emitting opening OP2-E may expose at least a portion of the second anode AE2. The third light emitting opening OP3-E may expose at least a portion of the third anode AE3.

In an embodiment, the first light emitting area PXA-R may be defined as an area of an upper surface of the first anode AE1, which is exposed by the first light emitting opening OP1-E. The second light emitting area PXA-G may be defined as an area of an upper surface of the second anode AE2, which is exposed by the second light emitting opening OP2-E. The third light emitting area PXA-B may be defined as an area of an upper surface of the third anode AE3, which is exposed by the third light emitting opening OP3-E.

The sacrificial patterns SP1, SP2, and SP3 may include the first sacrificial pattern SP1, the second sacrificial pattern SP2, and the third sacrificial pattern SP3. The first to third sacrificial patterns SP1, SP2, and SP3 may be arranged on the upper surfaces of the first to third anodes AE1, AE2, and AE3, respectively. First to third sacrificial openings OP1-S, OP2-S, and OP3-S overlapping the first to third light emitting openings OP1-E, OP2-E, and OP3-E in a plan view may be defined in the first to third sacrificial patterns SP1, SP2, and SP3, respectively.

In an embodiment, first to third partition wall openings OP1-P, OP2-P, and OP3-P overlapping the first to third light emitting openings OP1-E, OP2-E, and OP3-E, respectively, may be defined in the partition wall PW.

In an embodiment, the first to third light emitting patterns EP1, EP2, and EP3 and the first to third cathodes CE1, CE2, and CE3 may be physically separated by the second partition wall layer L2 forming the tip portion and may be formed inside the light emitting openings OP1-E, OP2-E, and OP3-E and the partition wall openings OP1-P, OP2-P, and OP3-P. That is, the light emitting elements ED1, ED2, and ED3 may be arranged inside the partition wall openings OP1-P, OP2-P, and OP3-P and the light emitting openings OP1-E, OP2-E, and OP3-E. For example, the first light emitting element ED1 may be disposed inside the first partition wall opening OP1-P and the first light emitting opening OP1-E, the second light emitting element ED2 may be disposed inside the second partition wall opening OP2-P and the second light emitting opening OP2-E, and the third light emitting element ED3 may be disposed inside the third partition wall opening OP3-P and the third light emitting opening OP3-E,

According to the present disclosure, the plurality of first light emitting patterns EP1 may be patterned and deposited in units of pixels by the tip portion defined in the partition wall PW. That is, the first light emitting patterns EP1 may be commonly formed using an open mask but may be easily divided in units of pixels by the partition wall PW.

On the other hand, when the first light emitting patterns EP1 are patterned using a fine metal mask (FMM), a support spacer protruding from a conductive partition wall to support the FMM should be provided. Further, since the FMM is spaced apart from a base surface, on which the patterning is performed, by a height of the partition wall PW and the spacer, implementation in a high resolution may be limited. Further, as the FMM is in contact with the spacer, after the patterning process for the first light emitting patterns EP1, the spacer may be damaged due to foreign substances remaining on the spacer or stamping of the FMM. Accordingly, a defective display panel may be formed.

According to an embodiment, the partition wall PW is included so that physical separation between the light emitting elements ED1, ED2, and ED3 may be easily performed. Accordingly, current leakage or driving errors between the adjacent light emitting areas PXA-R, PXA-G, and PXA-B may be prevented, and independent driving for each of the light emitting elements ED1, ED2, and ED3 may be performed.

In particular, since the plurality of first light emitting patterns EP1 are patterned without a mask in contact with an inner component inside the display area DA (see FIG. 1B), a defect rate is reduced, and thus the display panel DP having improved process reliability may be provided. As the patterning may be performed even when the separate support spacer protruding from the partition wall PW is not provided, areas of the light emitting areas PXA-R, PXA-G, and PXA-B may be minimized, and thus the display panel DP that easily implements a high resolution may be provided.

Further, in manufacturing a large-area display panel DP, the display panel DP may be provided in which process cost may be reduced as production of a large-area mask is omitted, and process reliability may be improved as the display panel DP is not affected by defects that may occur in the large-area mask. The description of the plurality of first light emitting patterns EP1 may be equally applied to the plurality of second light emitting patterns EP2 and the plurality of third light emitting patterns EP3.

The thin film encapsulation layer TFE may include the lower encapsulation inorganic patterns LIL, the common inorganic film CLIL, the encapsulation organic film OL, and the upper encapsulation inorganic film UIL.

The lower encapsulation inorganic patterns LIL may include a first lower encapsulation inorganic pattern LIL1 that covers the first light emitting element ED1, a second lower encapsulation inorganic pattern LIL2 that covers the second light emitting element ED2, and a third lower encapsulation inorganic pattern LIL3 that covers the third light emitting element ED3. The first to third lower encapsulation inorganic patterns LIL1, LIL2, and LIL3 may overlap the first to third light emitting openings OP1-E, OP2-E, and OP3-E in a plan view, respectively. The first to third lower encapsulation inorganic patterns LIL1, LIL2, and LIL3 may be provided in the form of patterns spaced apart from each other.

The common inorganic film CLIL may cover the first to third lower encapsulation inorganic patterns LIL1, LIL2, and LIL3 and fill spaces between the partition wall PW and the first to third lower encapsulation inorganic patterns LIL1, LIL2, and LIL3. The common inorganic film CLIL may cover the first to third lower encapsulation inorganic patterns LIL1, LIL2, and LIL3 that are dried. For example, the common inorganic film CLIL may cover the first to third lower encapsulation inorganic patterns LIL1, LIL2, and LIL3 in a state in which outer surfaces of the first to third lower encapsulation inorganic patterns LIL1, LIL2, and LIL3 are dried and thus there is no residual moisture.

Inner areas ES1, ES2, and ES3 may be defined in the common inorganic film CLIL. The inner areas ES1, ES2, and ES3 may be empty spaces formed during a process of depositing the common inorganic film CLIL. For example, the inner areas ES1, ES2, and ES3 may be filled with gas. The inner areas ES1, ES2, and ES3 may include the first inner area ES1, the second inner area ES2, and the third inner area ES3.

The first inner area ES1 may have a shape surrounding the first light emitting opening OP1-E on a plane (i.e., in a plan view). A portion of the first inner area ES1 may overlap the first lower encapsulation inorganic pattern LII,1 on a plane, and the first inner area ES1 may overlap the partition wall PW on a plane. That is, the first inner area ES1 may be formed between the first lower encapsulation inorganic pattern LIL1 and the partition wall PW and overlap the first lower encapsulation inorganic pattern LIL1 and the partition wall PW in a plan view.

The second inner area ES2 may have a shape surrounding the second light emitting opening OP2-E on a plane (i.e., in a plan view). A portion of the second inner area ES2 may overlap the second lower encapsulation inorganic pattern LIL2 on a plane, and the second inner area ES2 may overlap the partition wall PW on a plane. That is, the second inner area ES2 may be formed between the second lower encapsulation inorganic pattern LIL2 and the partition wall PW and overlap the second lower encapsulation inorganic pattern LIL2 and the partition wall PW in a plan view.

The third inner area ES3 may have a shape surrounding the third light emitting opening OP3-E on a plane (i.e., in a plan view). A portion of the third inner area ES3 may overlap the third lower encapsulation inorganic pattern LIL3 on a plane, and the third inner area ES3 may overlap the partition wall PW on a plane. That is, the third inner area ES3 may be formed between the third lower encapsulation inorganic pattern LIL3 and the partition wall PW and overlap the third lower encapsulation inorganic pattern LIL3 and the partition wall PW in a plan view.

The common inorganic film CLIL may cover the upper surface U_LIL (see FIG. 5), the first side surfaces S1_LIL (see FIG. 5), the lower surfaces B_LIL (see FIG. 5), and the second side surfaces S2_LIL (see FIG. 5) of each of the first to third lower encapsulation inorganic patterns LIL1, LIL2, and LIL3. That is, the common inorganic film CLIL may cover the outer surfaces of the first to third lower encapsulation inorganic patterns LIL1, LIL2, and LIL3 and may be formed while surrounding the first to third inner areas ES1, ES2, and ES3.

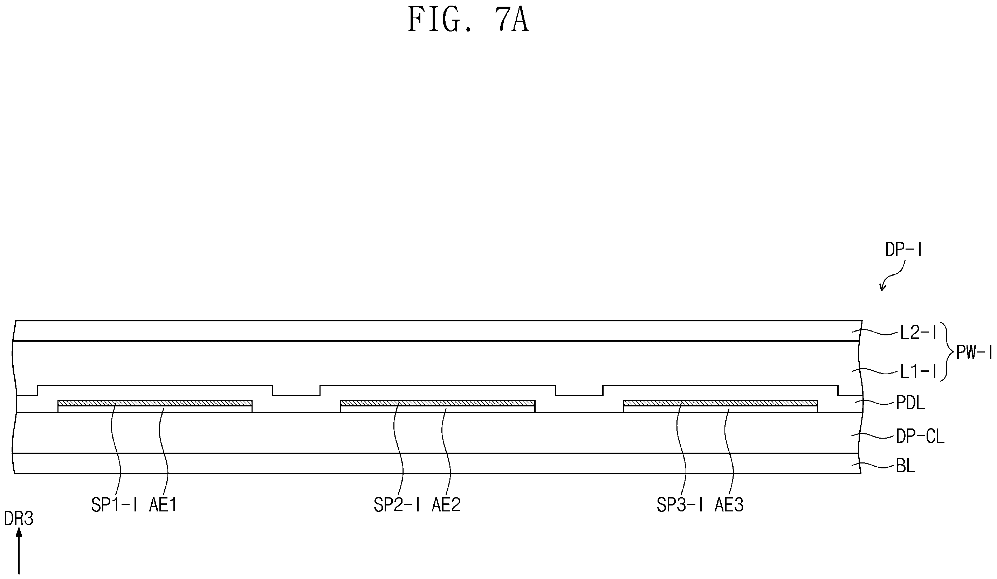

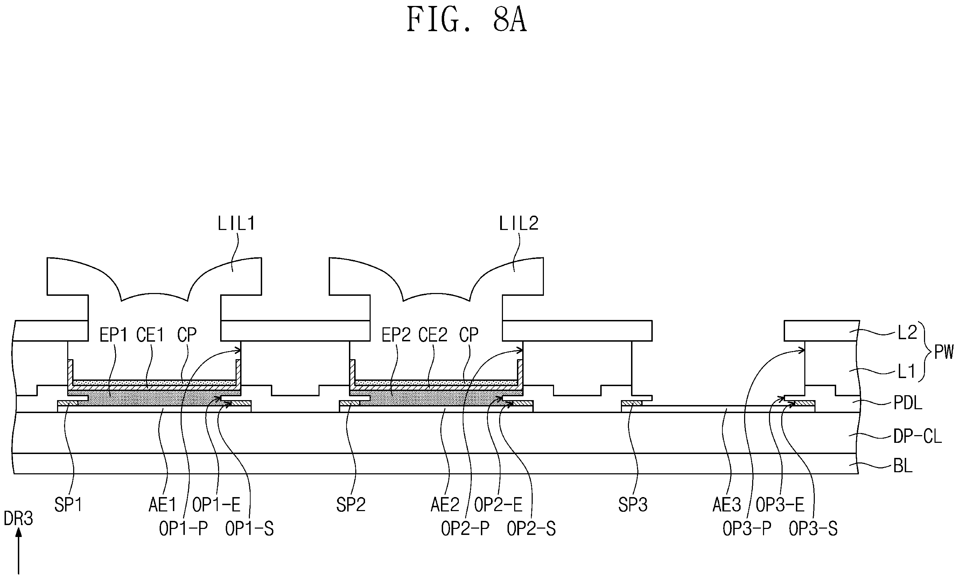

FIGS. 7A to 7I and 8A to 8E are cross-sectional views illustrating some of the operations of a method of manufacturing a display panel according to an embodiment of the present disclosure. In the description of FIGS. 7A to 8E, the same/similar reference numerals will be used for the same/similar components described in to FIGS. 1 to 6, and duplicated descriptions thereof will be omitted.

A method of manufacturing a display panel according to an embodiment of the present disclosure may include: an operation of providing a preliminary display panel including a base layer, a pixel defining film disposed on the base layer, and a preliminary partition wall disposed on the pixel defining film; an operation of forming a partition wall defining a partition wall opening therein from the preliminary partition wall; an operation of etching the pixel defining film to form a light emitting opening overlapping the partition wall opening in a plan view; an operation of forming a light emitting element and a lower encapsulation inorganic pattern that covers the light emitting element inside the light emitting opening and the partition wall opening; and an operation of drying outer surfaces of the partition wall and the lower encapsulation inorganic pattern.

Hereinafter, a method of forming the three light emitting elements ED1, ED2, and ED3, the lower encapsulation inorganic patterns LIL1, LIL2, and LIL3 that cover the light emitting elements ED1, ED2, and ED3, the common inorganic film CLIL, the encapsulation organic film OL, and the upper encapsulation inorganic film UIL will be described through FIGS. 7A to 8E. The display panel DP formed through FIGS. 7A to 8E may correspond to the display panel DP of FIG. 6.

Referring to FIG. 7A, the method of manufacturing a display panel according to the present disclosure may include providing a preliminary display panel DP-I. The preliminary display panel DP-I provided in an embodiment may include the base layer BL, the circuit element layer DP-CL, the first to third anodes AE1, AE2, and AE3, first to third preliminary sacrificial patterns SP1-I, SP2-I, and SP3-I, the pixel defining film PDL, and a preliminary partition wall PW-I. The preliminary partition wall PW-I may include a first preliminary partition wall layer L1-I and a second preliminary partition wall layer L2-I.

The circuit element layer DP-CL may be formed by a general method of manufacturing a circuit element, in which an insulating layer, a semiconductor layer, and a conductive layer are formed through a coating method or a deposition method, the insulating layer, the semiconductor layer, and the conductive layer are selectively patterned by a photolithography and etching process, and a semiconductor pattern, a conductive pattern, a signal line or the like are formed.

The first anode AE1 and the first preliminary sacrificial pattern SP1-I may be formed by the same patterning process, the second anode AE2 and the second preliminary sacrificial pattern SP2-I may be formed by the same patterning process, and the third anode AE3 and the third preliminary sacrificial pattern SP3-I may be formed by the same patterning process. The pixel defining film PDL may be disposed on the base layer BL. The pixel defining film PDL may cover all the first to third anodes AE1, AE2, and AE3 and the first to third preliminary sacrificial patterns SP1-I, SP2-I, and SP3-I.

The first preliminary partition wall layer L1-I may be disposed on the pixel defining film PDL. The first preliminary partition wall layer L1-I may be formed through a process of depositing a conductive material. The second preliminary partition wall layer L2-I may be disposed on the first preliminary partition wall layer L1-I. The second preliminary partition wall layer L2-I may be also formed through a process of depositing a conductive material. The first preliminary partition wall layer L1-I and the second preliminary partition wall layer L2-I may include a metal, a TCO, or a combination thereof. For example, the metal includes gold (Au), silver (Ag), aluminium (Al), magnesium (Mg), lithium (Li), molybdenum (Mo), titanium (Ti), copper (Cu), or alloys thereof. The TCO may include an indium tin oxide (ITO), an indium zinc oxide (IZO), a zinc oxide, an indium oxide, an indium gallium oxide, an indium gallium zinc oxide (IGZO) or an aluminium zinc oxide. In an embodiment of the present disclosure, the first preliminary partition wall layer L1-I may include aluminium (Al), and the second preliminary partition wall layer L2-I may include titanium (Ti). However, materials of the first preliminary partition wall layer L1-I and the second preliminary partition wall layer L2-I are not limited thereto.

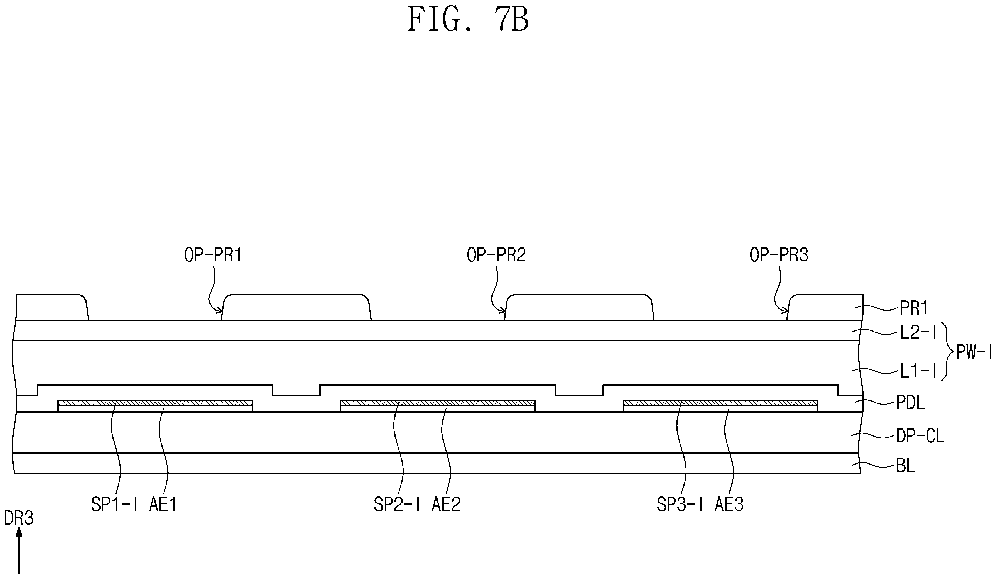

Thereafter, referring to FIG. 7B, the method of manufacturing a display panel according to the present disclosure may include an operation of forming a first photoresist layer PR1 on the preliminary partition wall PW-I. The first photoresist layer PR1 may be formed by forming a preliminary photoresist layer on the preliminary partition wall PW-I and then patterning the preliminary photoresist layer using a photo mask. A first photo opening OP-PR1, a second photo opening OP-PR2, and a third photo opening OP-PR3 may be formed in the first photoresist layer PR1 through a patterning process. The first photo opening OP-PR1 may overlap the first anode AE1, the second photo opening OP-PR2 may overlap the second anode AE2, and the third photo opening OP-PR3 may overlap the third anode AE3 in a plan view.

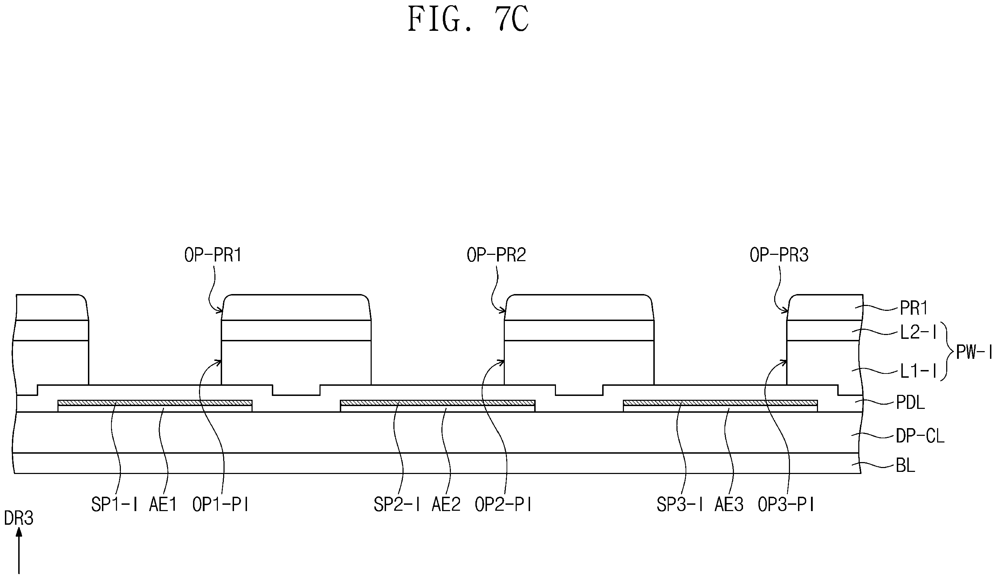

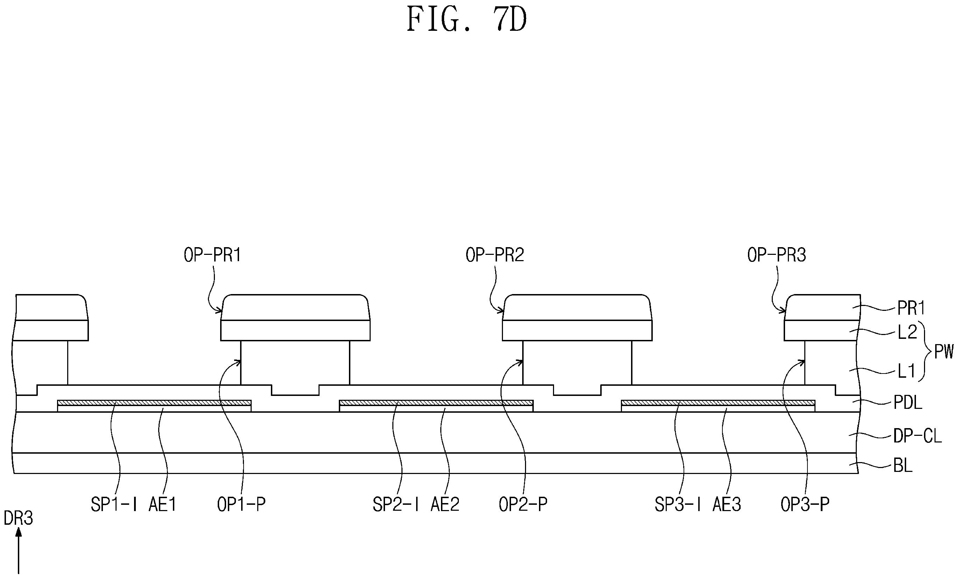

Thereafter, referring to FIGS. 7C and 7D, the method of manufacturing a display panel according to the present disclosure may include an operation of forming the partition wall PW defining the partition wall openings OP1-P, OP2-P, and OP3-P therein from the preliminary partition wall PW-I (see FIG. 7B). The operation of forming the partition wall PW may include an operation of forming the first partition wall layer L1 and the second partition wall layer L2, in which the partition wall openings OP1-P, OP2-P, and OP3-P are defined, by etching the first preliminary partition wall layer L1-I and the second preliminary partition wall layer L2-I.

First, as illustrated in FIG. 7C, in an operation of primarily etching the first preliminary partition wall layer L1-I and the second preliminary partition wall layer L2-I, the first preliminary partition wall layer L1-I and the second preliminary partition wall layer L2-I may be dry-etched using the first photoresist layer PR1 as a mask. A portion of the preliminary partition wall PW-I, which does not overlap the first photoresist layer PR1 in a plan view, may be etched and removed. For example, a first preliminary partition wall opening OP1-PI may be formed by removing a portion of the preliminary partition wall PW-I that overlaps the first photo opening OP-PR1, a second preliminary partition wall opening OP2-PI may be formed in a portion of the preliminary partition wall PW-I that overlaps the second photo opening OP-PR2, and a third preliminary partition wall opening OP3-PI may be formed in a portion of the preliminary partition wall PW-I that overlaps the third photo opening OP-PR3.

A primary dry etching process in an embodiment may be performed in an etching environment in which an etching selection ratio between the first preliminary partition wall layer L1-I and the second preliminary partition wall layer L2-I is substantially the same. Accordingly, an inner surface of the first preliminary partition wall layer L1-I and an inner surface of the second preliminary partition wall layer L2-I, which define the preliminary partition wall openings OP1-PI, OP2-PI and OP3-PI, may be substantially aligned with each other.

Thereafter, as illustrated in FIG. 7D, in an operation of secondarily etching the first preliminary partition wall layer L1-I (see FIG. 7C), the first preliminary partition wall layer L1-I may be wet-etched using the first photoresist layer PR1 as a mask. Accordingly, a portion of the first preliminary partition wall layer L1-I may be etched to form the partition wall openings OP1-P, OP2-P, and OP3-P. The partition wall openings OP1-P, OP2-P, and OP3-P may include the first partition wall opening OP1-P, the second partition wall opening OP2-P, and the third partition wall opening OP3-P. The first partition wall opening OP1-P may be formed to overlap the first anode AE1, the second partition wall opening OP2-P may be formed to overlap the second anode AE2, and the third partition wall opening OP3-P may be formed to overlap the third anode AE3 in a plan view.

The secondary wet etching process in the present disclosure may be performed in an environment where an etch selection ratio between the first preliminary partition wall layer L1-I and the second preliminary partition wall layer L2-I (see FIG. 7C) is high. Accordingly, an inner surface of the partition wall PW defining the partition wall openings OP1-P, OP2-P, and OP3-P may have an undercut shape on a cross section. In detail, as an etch rate of the first preliminary partition wall layer L1-I with respect to an etching solution is greater than an etch rate of the second preliminary partition wall layer L2-I with respect to the etching solution, the first preliminary partition wall layer L1-I may be mainly etched. Accordingly, the first inner surface of the first partition wall layer L1 may be more recessed inward than the second inner surface of the second partition wall layer L2. The tip portion may be formed in the partition wall PW by a portion of the second partition wall layer L2 protruding further from the first partition wall layer L1.

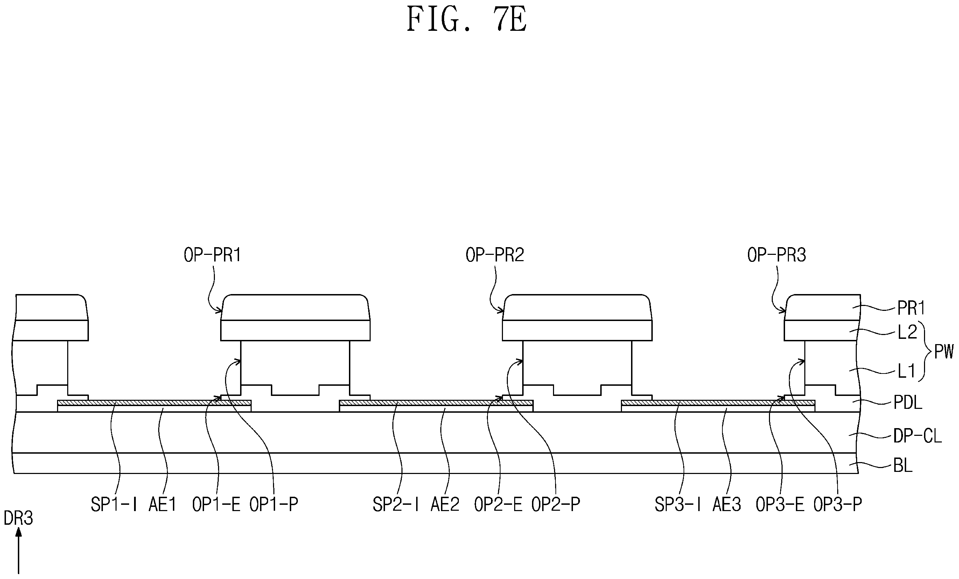

Thereafter, referring to FIG. 7E, the method of manufacturing a display panel according to the present disclosure may include an operation of etching the pixel defining film PDL to form the light emitting openings OP1-E, OP2-E, and OP3-E overlapping the partition wall openings OP1-P, OP2-P, and OP3-P in a plan view.

In the operation of etching the pixel defining film PDL, the pixel defining film PDL may be dry-etched using the first photoresist layer PR1 and the partition wall PW (e.g., the second partition wall layer L2) as a mask. A portion of the pixel defining film PDL, which does not overlap the first photoresist layer PR1 and the partition wall PW in a plan view, may be etched and removed. As a result, the light emitting openings OP1-E, OP2-E, and OP3-E overlapping the partition wall openings OP1-P, OP2-P, and OP3-P in a plan view may be formed in the pixel defining film PDL. The light emitting openings OP1-E, OP2-E, and OP3-E may include the first light emitting opening OP1-E that overlaps the first partition wall opening OP1-P, the second light emitting opening OP2-E that overlaps the second partition wall opening OP2-P, and the third light emitting opening OP3-E that overlaps the third partition wall opening OP3-P in a plan view.

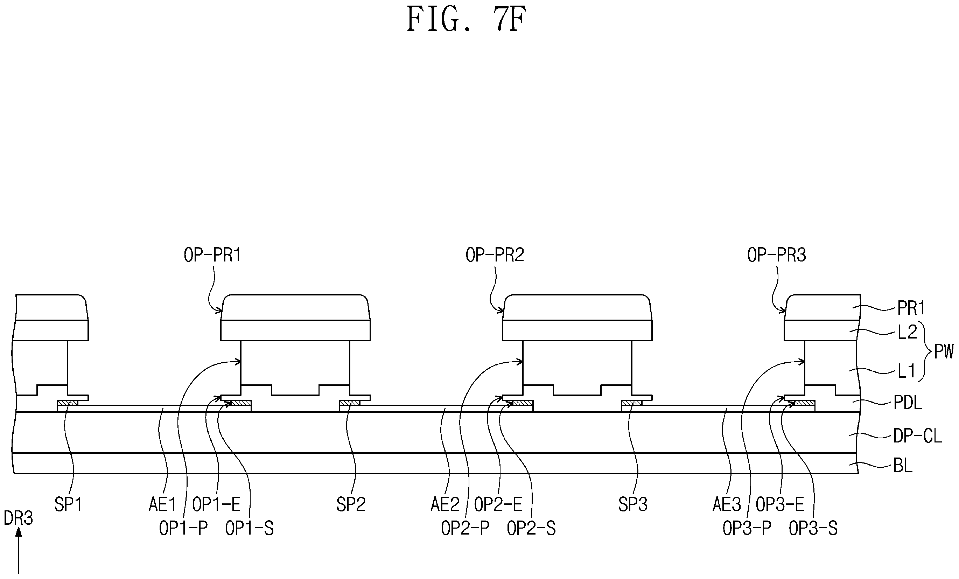

Thereafter, referring to FIG. 7F, the method of manufacturing a display panel according to the present disclosure may include an operation of etching the first to third preliminary sacrificial patterns SP1-I, SP2-I, and SP3-I (see FIG. 7E) to form the sacrificial patterns SP1, SP2, and SP3 defining the sacrificial openings OP1-S, OP2-S, and OP3-S overlapping the light emitting openings OP1-E, OP2-E, and OP3-E in a plan view, respectively.

In the operation of etching the first to third preliminary sacrificial patterns SP1-I, SP2-I, and SP3-I, the first to third preliminary sacrificial patterns SP1-I, SP2-I, and SP3-I may be wet-etched using the first photoresist layer PR1 and the partition wall PW (e.g., the second partition wall layer L2) as a mask. Portions of the first to third preliminary sacrificial patterns SP1-I, SP2-I, and SP3-I, which do not overlap the first photoresist layer PR1 and the partition wall PW in a plan view, may be etched and removed. As a result, the sacrificial patterns SP1, SP2, and SP3 may be formed from the first to third preliminary sacrificial patterns SP1-I, SP2-I, and SP3-I.

The sacrificial patterns SP1, SP2, and SP3 may include the first sacrificial pattern SP1, the second sacrificial pattern SP2, and the third sacrificial pattern SP3. The first sacrificial opening OP1-S overlapping the first light emitting opening OP1-E in a plan view may be formed in the first sacrificial pattern SP1, the second sacrificial opening OP2-S overlapping the second light emitting opening OP2-E in a plan view may be formed in the second sacrificial pattern SP2, and the third sacrificial opening OP3-S overlapping the third light emitting opening OP3-E in a plan view may be formed in the third sacrificial pattern SP3.

The etching process of the sacrificial patterns SP1, SP2, and SP3 may be performed in an environment in which an etching selection ratio between the sacrificial patterns SP1, SP2, and SP3 and the anodes AE1, AE2, and AE3 is high, and therefore, the anodes AE1, AE2, and AE3 may be prevented from being etched together. That is, as the sacrificial patterns SP1, SP2, and SP3 having a higher etch rate than an etch rate of the anodes AE1, AE2, and AE3 are arranged between the pixel defining film PDL and the anodes AE1, AE2, and AE3, the anodes AE1, AE2, and AE3 may be prevented from being etched together and damaged during the etching process.

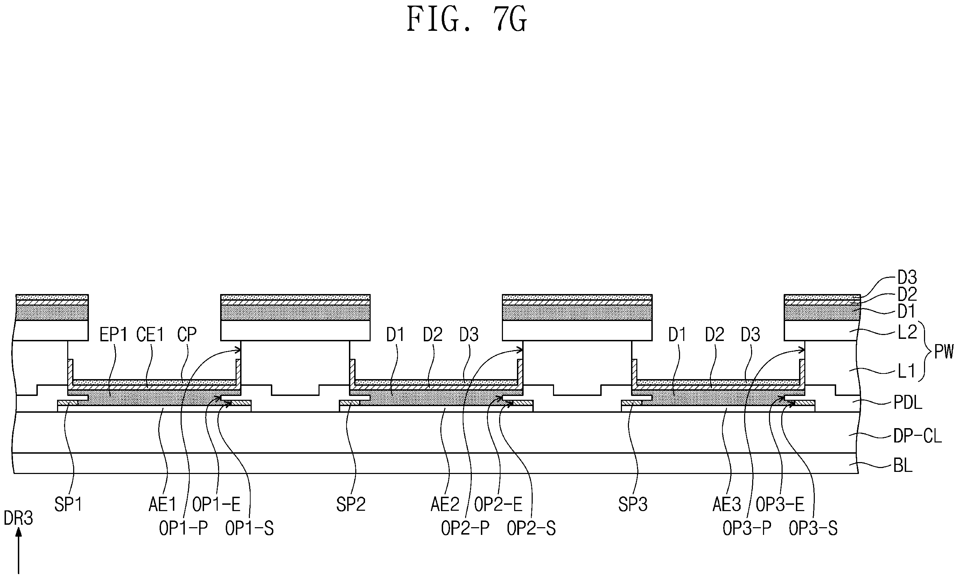

Thereafter, referring to FIGS. 7G to 8B, the method of manufacturing a display panel according to the present disclosure may include an operation of forming the light emitting elements ED1, ED2, and ED3 inside the light emitting openings OP1-E, OP2-E, and OP3-E and the partition wall openings OP1-P, OP2-P, and OP3-P and the lower encapsulation inorganic patterns LIL1, LIL2, and LIL3 covering the light emitting elements ED1, ED2, and ED3 after removing the first photoresist layer PR1 (see FIG. 7F).

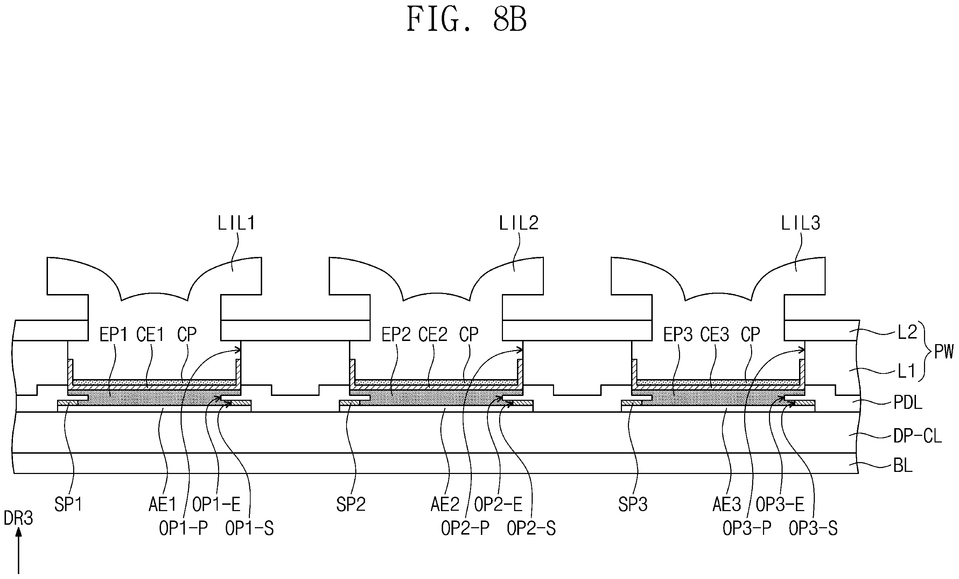

The operation of forming the light emitting elements ED1, ED2, and ED3 and the lower encapsulation inorganic patterns LIL1, LIL2, and LIL3 may include an operation of forming the first light emitting element ED1 and the first lower encapsulation inorganic pattern LIL1 that covers the first light emitting element ED1, an operation of forming the second light emitting element ED2 and the second lower encapsulation inorganic pattern LIL2 that covers the second light emitting element ED2, and an operation of forming the third light emitting element ED3 and the third lower encapsulation inorganic pattern LIL3 that covers the third light emitting element ED3. The operation of forming the first light emitting element ED 1 and the first lower encapsulation inorganic pattern LIL1 is described through FIGS. 7G to 7I, and the operation of forming the second light emitting element ED2 and the second lower encapsulation inorganic pattern LIL2 and the operation of forming the third light emitting element ED3 and the third lower encapsulation inorganic pattern LIL3 are described through FIGS. 8A and 8B.

Referring to FIG. 7G, the operation of forming the first light emitting element ED1 may include an operation of forming the first light emitting pattern EP 1 and an operation of forming the first cathode CE1. The operation of forming the first light emitting pattern EP1 may include a process of depositing a light emitting layer. For example, the operation of forming the first light emitting pattern EP1 may include an operation of thermally evaporating the light emitting layer. The light emitting layer may be separated by the tip portion formed in the partition wall PW and may be deposited inside the first to third partition wall openings OP1-P, OP2-P, and OP3-P and on the partition wall PW. The light emitting layer formed in the first partition wall opening OP1-P may form the first light emitting pattern EP1, and the light emitting layer formed inside the second and third partition wall openings OP2-P and OP3-P and on the partition wall PW may form a first dummy layer D1. That is, the first light emitting pattern EP1 may be formed on the first anode AE1 to overlap the first partition wall opening OP1-P in a plan view, and the first light emitting pattern EP1 may be formed to cover the first anode AE1 and the pixel defining film PDL.

The first dummy layer D1 formed together in the operation of forming the first light emitting pattern EP1 may include an organic material. For example, the first dummy layer D1 may include the same material as the material of the first light emitting pattern EP1. The first dummy layer D1 together with the first light emitting pattern EP1 may be simultaneously formed through one process and formed separately from the first light emitting pattern EP1 by the undercut shape of the partition wall PW.

The operation of forming the first cathode CE1 may include a process of depositing a cathode layer. For example, the operation of forming the first cathode CE1 may include an operation of sputtering the cathode layer. The cathode layer may be separated by the tip portion formed in the partition wall PW and may be deposited inside the first to third partition wall openings OP1-P, OP2-P, and OP3-P and on the partition wall PW. The cathode layer formed in the first partition wall opening OP1-P may form the first cathode CE1, and the cathode layer formed inside the second and third partition wall openings OP2-P and OP3-P and on the partition wall PW may form a second dummy layer D2. That is, the first cathode CE1 may be formed on the first light emitting pattern EP1 to overlap the first partition wall opening OP1-P in a plan view, and the first cathode CE1 may be formed to cover the first light emitting pattern EP1. Further, the first cathode CE1 may be in contact with an inner surface of the first partition wall layer L1 and extend along the inner surface of the first partition wall layer L1.

The second dummy layer D2 formed together in the operation of forming the first cathode CE1 may include a conductive material. For example, the second dummy layer D2 may include the same material as the material of the first cathode CE1. The second dummy layer D2 together with the first cathode CE1 may be simultaneously formed through one process and formed separately from the first cathode CE1 by the undercut shape of the partition wall PW.

The first anode AE1, the first light emitting pattern EP1, and the first cathode CE1 may be sequentially laminated in the third direction DR3. The first anode AE1, the first light emitting pattern EP1, and the first cathode CE1 may form the first light emitting element ED1.

The method of manufacturing a display panel according to the present disclosure may include an operation of forming the capping pattern CP. The operation of forming the capping pattern CP may include a process of depositing a capping pattern layer. The capping pattern layer may be separated by the tip portion formed in the partition wall PW and may be deposited inside the first to third partition wall openings OP1-P, OP2-P, and OP3-P and on the partition wall PW. The capping pattern layer formed in the first partition wall opening OP1-P may form the capping pattern CP, and the capping pattern layer formed inside the second and third partition wall openings OP2-P and OP3-P and on the partition wall PW may form a third dummy layer D3.

The third dummy layer D3 formed together in the operation of forming the capping pattern CP may include a conductive material. For example, the third dummy layer D3 may include the same material as the material of the capping pattern CP. The third dummy layer D3 together with the capping pattern CP may be simultaneously formed through one process and formed separately from the capping pattern CP by the undercut shape of the partition wall PW. In an embodiment of the present disclosure, a process of forming the capping pattern CP and the third dummy layer D3 may be omitted.

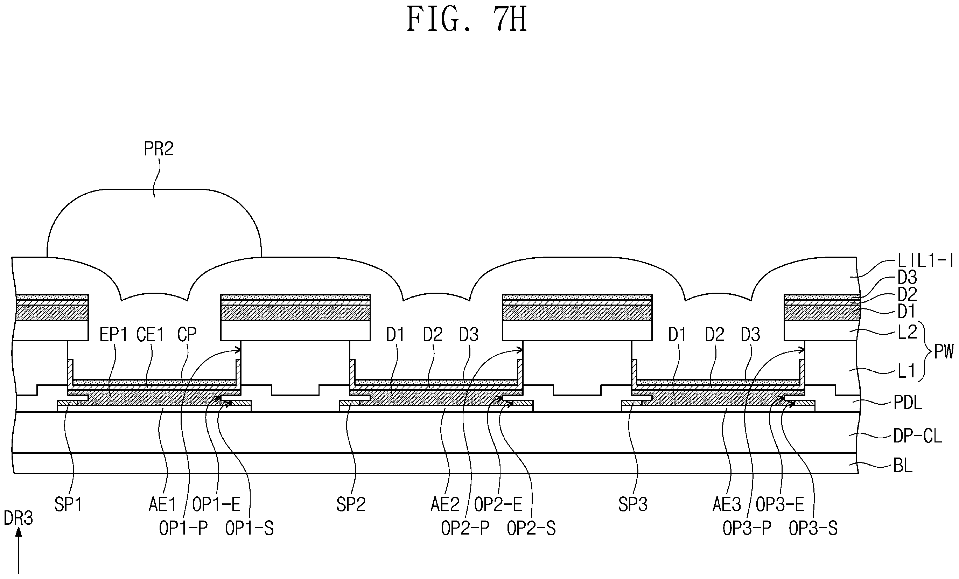

Thereafter, referring to FIG. 7H, the operation of forming the first lower encapsulation inorganic pattern LIL1 may include an operation of depositing a first lower encapsulation inorganic layer LII,1-I. The first lower encapsulation inorganic layer LIL1-I may be formed through a deposition process. In an embodiment, the first lower encapsulation inorganic layer LII,1-I may be formed through a chemical vapor deposition (CVD) process. The first lower encapsulation inorganic layer LIL1-I may be formed to cover the first cathode CE1 (or the capping pattern CP) and the partition wall PW. A portion of the first lower encapsulation inorganic layer LIL1-I may fill the first partition wall opening OP1-P.

Thereafter, the method of manufacturing a display panel according to the present disclosure may include an operation of forming a second photoresist layer PR2. In the operation of forming the second photoresist layer PR2, the second photoresist layer PR2 may be formed by forming a preliminary photoresist layer, and then patterning the preliminary photoresist layer using a photo mask. Through the patterning process, the second photoresist layer PR2 may be formed in a pattern form corresponding to the first light emitting element ED1.

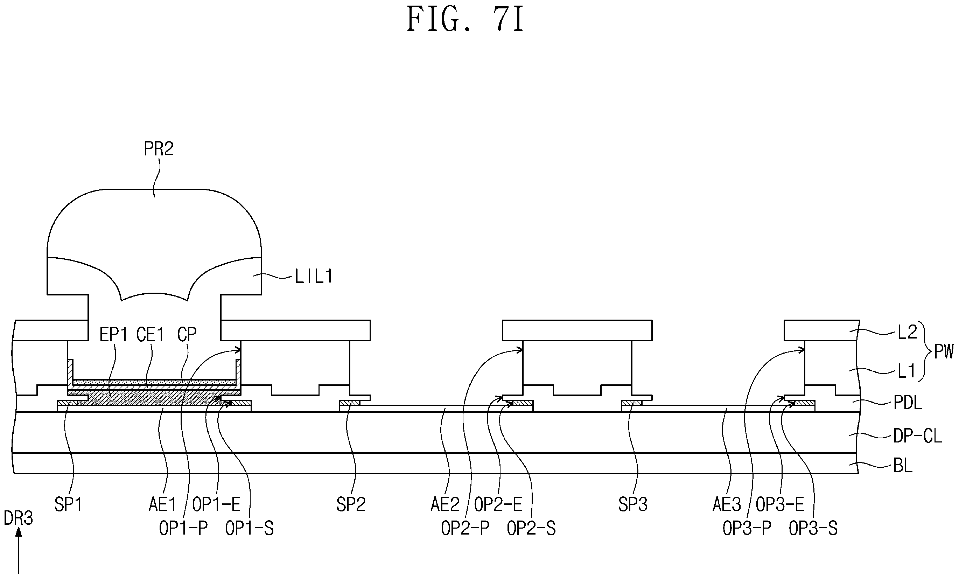

Referring to FIG. 7I, the operation of forming the first lower encapsulation inorganic pattern LIL1 may include an operation of removing a portion of the first lower encapsulation inorganic layer LIL1-I (see FIG. 7H), which does not overlap the first light emitting element ED1 in a plan view.

In the operation of removing the portion of the first lower encapsulation inorganic layer LIL1-I, which does not overlap the first light emitting element ED1 in a plan view, the first lower encapsulation inorganic layer LIL1-I may be dry-etched using the second photoresist layer PR2 as a mask. A portion of the first lower encapsulation inorganic layer LII,1-I, which does not overlap the second photoresist layer PR2 in a plan view, may be removed, and the first lower encapsulation inorganic pattern LIL1 may be formed in a remaining portion of the first lower encapsulation inorganic layer LII,1-I, which is not etched.

Thereafter, the method of manufacturing a display panel according to the present disclosure may include an operation of removing the dummy layers D1, D2, and D3. The second and third dummy layers D2 and D3 among the dummy layers D1, D2, and D3 may be removed through wet etching, and the first dummy layer D1 among the dummy layers D1, D2, and D3 may be removed using a stripper.

Thereafter, referring to FIG. 8A, in the method of manufacturing a display panel according to the present disclosure, after the second photoresist layer PR2 (see FIG. 7I) is removed, the second light emitting element ED2, the capping pattern CP, and the second lower encapsulation inorganic pattern LIL2 may be formed. The process of forming the second light emitting element ED2, the capping pattern CP, and the second lower encapsulation inorganic pattern LIL2 may be substantially the same as the process of forming the first light emitting element ED1, the capping pattern CP, and the first lower encapsulation inorganic pattern LIL1, which has been described through FIGS. 7G to 7I.

Thereafter, referring to FIG. 8B, in the method of manufacturing a display panel according to the present disclosure, the third light emitting element ED3, the capping pattern CP, and the third lower encapsulation inorganic pattern LIL3 may be formed. The process of forming the third light emitting element ED3, the capping pattern CP, and the third lower encapsulation inorganic pattern LIL3 may be substantially the same as the process of forming the first light emitting element ED1, the capping pattern CP, and the first lower encapsulation inorganic pattern LIL1, which has been described through FIGS. 7G to 7I.

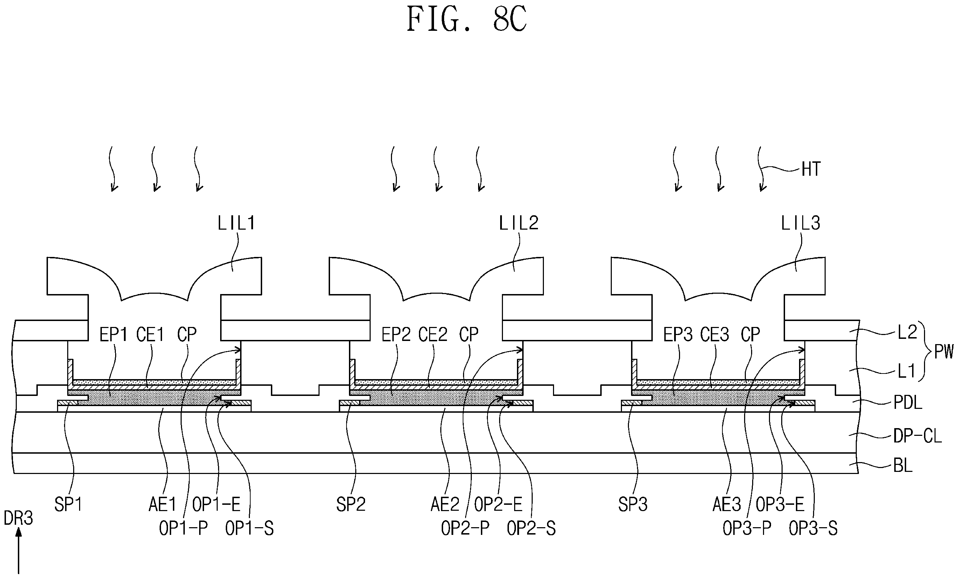

Thereafter, referring to FIG. 8C, the method of manufacturing a display panel according to the present disclosure may include an operation of drying the outer surfaces of the partition wall PW and the lower encapsulation inorganic patterns LIL1, LIL2, and LIL3. The operation of drying the outer surfaces of the partition wall PW and the lower encapsulation inorganic patterns LIL1, LIL2, and LIL3 may be an operation of applying heat HT to the outer surfaces of the partition wall PW and the lower encapsulation inorganic patterns LIL1, LIL2, and LIL3 to evaporate residual moisture. As a result of the above process, moisture may not be present on the outer surfaces of the partition wall PW and the lower encapsulation inorganic patterns LIL1, LIL2, and LIL3.

According to the present disclosure, an organic material that absorbs moisture (the first dummy layer D1 in FIG. 7I) between the lower encapsulation inorganic pattern LIL and the partition wall PW is removed, and the residual moisture may be removed through a drying process. Thus, a phenomenon in which foreign substances are introduced through the moisture between the lower encapsulation inorganic pattern LIL and the partition wall PW may be reduced or removed. As a result, pixel defects (dark spots, pixel shrinkage, or the like) of the display panel, which are caused by foreign substances, may be effectively reduced or removed.

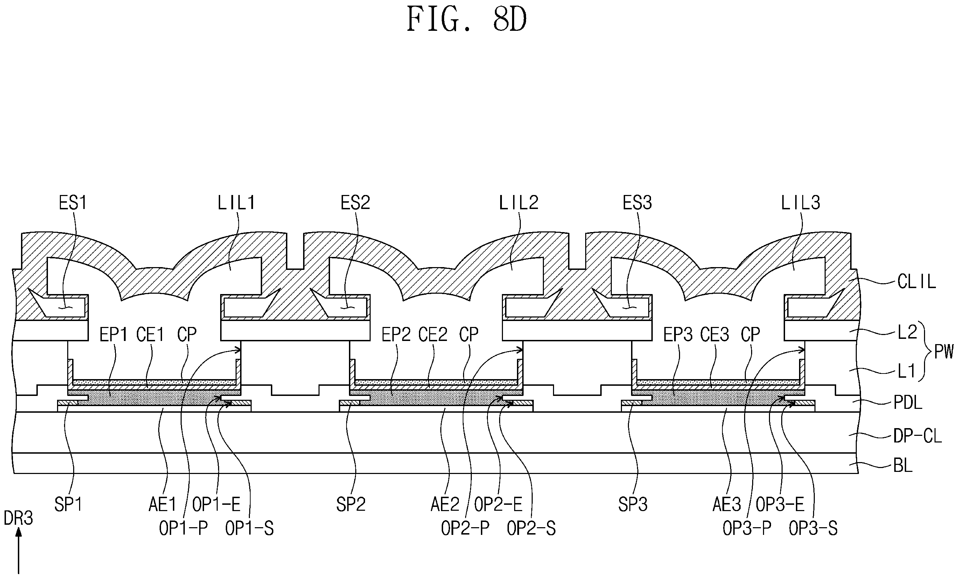

Thereafter, referring to FIG. 8D, the method of manufacturing a display panel according to the present disclosure may include an operation of forming the common inorganic film CLIL that covers the first to third lower encapsulation inorganic patterns LIL1, LIL2, and LIL3.

The common inorganic film CLIL may be formed to cover the first to third lower encapsulation inorganic patterns LIL1, LIL2, and LIL3 that are dried. The common inorganic film CLIL may cover the upper surface U_LIL (see FIG. 5), the first side surfaces S1_LIL (see FIG. 5), the lower surfaces B_LIL (see FIG. 5), and the second side surfaces S2_LIL (see FIG. 5) of each of the first to third lower encapsulation inorganic patterns LIL1, LIL2, and LIL3.

The common inorganic film CLEL may fill spaces between the partition wall PW and the first to third lower encapsulation inorganic patterns LIL1, LIL2, and LIL3. In the process of forming the common inorganic film CLIL, the first to third inner areas ES1, ES2, and ES3, which are empty spaces, may be formed. The first inner area ES1 may be formed between the first lower encapsulation inorganic pattern LIL1 and the partition wall PW and overlap the first lower encapsulation inorganic pattern LIL1 and the partition wall PW in a plan view, the second inner area ES2 may be formed between the second lower encapsulation inorganic pattern LIL2 and the partition wall PW and overlap the second lower encapsulation inorganic pattern LIL2 and the partition wall PW in a plan view, and the third inner area ES3 may be formed between the third lower encapsulation inorganic pattern LIL3 and the partition wall PW and overlap the third lower encapsulation inorganic pattern LIL3 and the partition wall PW in a plan view. That is, the common inorganic film CLIL may cover the outer surfaces of the first to third lower encapsulation inorganic patterns LIL1, LIL2, and LIL3 and may be formed while surrounding the first to third inner areas ES1, ES2, and ES3.

In the related art, the encapsulation organic film OL is thickened so that the thin film encapsulation layer TFE has a low dielectric constant. However, in the present disclosure, the inner area ES is defined in the common inorganic film CLIL, and thus the common inorganic film CLIL may have a low dielectric constant close to 1. Thus, the thickness of the encapsulation organic film OL of the present disclosure may be reduced, and the thickness of the encapsulation organic film OL may be reduced to improve touch sensitivity.

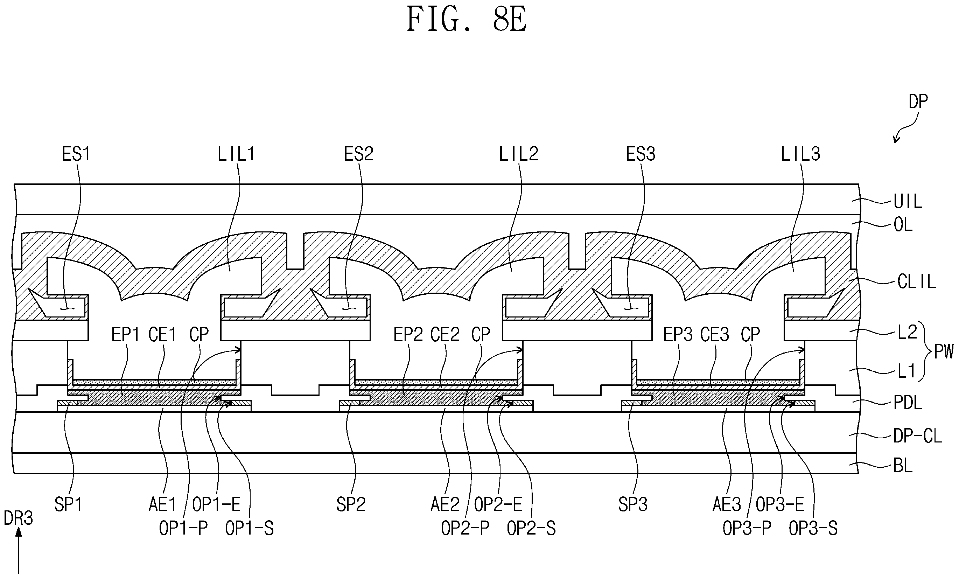

Thereafter referring to FIG. 8E, the method of manufacturing a display panel according to the present disclosure may include an operation of completing the display panel DP by forming the encapsulation organic film OL and the upper encapsulation inorganic film UIL. The encapsulation organic film OL may be formed by applying an organic material in an inkjet method, but the present disclosure is not limited thereto. The encapsulation organic film OL provides a flattened upper surface. Thereafter, the upper encapsulation inorganic film UIL may be formed by depositing an inorganic material. Therefore, the display panel DP including the base layer BL, the circuit element layer DP-CL, the display element layer DP-OLED, and the thin film encapsulation Layer TFE may be formed.

FIG. 9 is a cross-sectional view along line II-II' of FIG. 4. The cross-sectional view of FIG. 9 corresponds to the cross-sectional view of FIG. 6 and illustrates an embodiment of the present disclosure. In description of FIG. 9, the same/similar reference numerals are used for the same/similar components described in FIGS. 5 and 6, and a duplicated description thereof will be omitted.

Referring to FIG. 9, a display panel DPa may include the base layer BL, the circuit element layer DP-CL, the display element layer DP-OLED, and a thin film encapsulation layer TFEa. The thin film encapsulation layer TFEa may include the lower encapsulation inorganic patterns LIL1, LIL2, and LIL3, the additional encapsulation inorganic patterns ALIL1, ALIL2, and ALIL3, a common inorganic film CLILa, the encapsulation organic film OL, and the upper encapsulation inorganic film UIL.

The thin film encapsulation layer TFEa of FIG. 9 may further include the additional encapsulation inorganic patterns ALIL1, ALIL2, and ALIL3 than the thin film encapsulation layer TFE of FIG. 6. The additional encapsulation inorganic patterns ALIL1, ALIL2, and ALIL3 may include the first additional encapsulation inorganic pattern ALIL1, the second additional encapsulation inorganic pattern ALIL2, and the third additional encapsulation inorganic pattern ALIL3.

The first additional encapsulation inorganic pattern ALIL1 may cover the dried first lower encapsulation inorganic pattern LIL1, the second additional encapsulation inorganic pattern ALIL2 may cover the dried second lower encapsulation inorganic pattern LIL2, and the third additional encapsulation inorganic pattern ALIL3 may cover the dried third lower encapsulation inorganic pattern LIL3. For example, the first to third additional encapsulation inorganic patterns ALIL1, ALIL2, and ALIL3 may cover the first to third lower encapsulation inorganic patterns LIL1, LIL2, and LIL3, respectively, in a state in which the outer surfaces of the first to third lower encapsulation inorganic patterns LIL1, LIL2, and LIL3 are dried and there is no residual moisture.

The first to third additional encapsulation inorganic patterns ALIL1, ALIL2, and ALIL3 may overlap the first to third light emitting openings OP1-E, OP2-E, and OP3-E, respectively, and the first to third additional encapsulation inorganic patterns ALIL1, ALIL2, and ALIL3 may be provided in a pattern form in which the first to third additional encapsulation inorganic patterns ALIL1, ALIL2, and ALIL3 are spaced apart from each other.

The common inorganic film CLILa may be disposed on the first to third additional encapsulation inorganic patterns ALIL1, ALIL2, and ALIL3 to cover the first to third additional encapsulation inorganic patterns ALIL1, ALIL2, and ALIL3. The description of the common inorganic film CLILa may be substantially the same as the description of the common inorganic film CLIL of FIG. 6. FIG. 9 does not illustrate the inner areas ES1, ES2, and ES3 (see FIG. 6), but the inner areas ES1, ES2, and ES3 may be defined in the common inorganic film CLILa of FIG. 9.

The process of manufacturing the display panel DPa of FIG. 9 may be partially different from the process of manufacturing the display panel DP, which has been described in FIGS. 7A to 8E. The method of manufacturing the display panel DPa of FIG. 9 may further include an operation of forming the additional encapsulation inorganic patterns ALIL1, ALIL2, and ALIL3 that cover the lower encapsulation inorganic patterns LIL1, LIL2, and LIL3. For example, the method may further include an operation of drying the outer surfaces of the partition wall PW and the first lower encapsulation inorganic pattern LIL1 and an operation of forming the first additional encapsulation inorganic pattern ALIL1 that covers the first lower encapsulation inorganic pattern LIL1, between the operation of removing the dummy layers D1, D2, and D3 of FIG. 7I and the process of forming the second light emitting element ED2 of FIG. 8A.

Further, the method of manufacturing the display panel DPa of FIG. 9 may further include an operation of drying the outer surfaces of the partition wall PW and the second lower encapsulation inorganic pattern LIL2 and an operation of forming the second additional encapsulation inorganic pattern ALIL2 that covers the second lower encapsulation inorganic pattern LIL2, between the operation of forming the second light emitting element ED2 and the second lower encapsulation inorganic pattern LIL2 of FIG. 8A and the process of forming the third light emitting element ED3 of FIG. 8B.

Further, the method of manufacturing the display panel DPa of FIG. 9 may further include an operation of drying the outer surfaces of the partition wall PW and the third lower encapsulation inorganic pattern LIL3 and an operation of forming the third additional encapsulation inorganic pattern ALIL3 that covers the third lower encapsulation inorganic pattern LIL3, after the operation of forming the third light emitting element ED3 and the third lower encapsulation inorganic pattern LIL3 of FIG. 8B.

In the method of manufacturing the display panel DPa of FIG. 9, the operation of drying the outer surfaces of the partition wall PW and the lower encapsulation inorganic patterns LIL1, LIL2, and LIL3 of FIG. 8C may be omitted. Further, the method of manufacturing the display panel DPa of FIG. 9 may include an operation of forming the common inorganic film CLILa that covers the first to third additional encapsulation inorganic patterns ALIL1, ALIL2, and ALIL3.

According to the above description, organic substances that absorb moisture between a lower encapsulation inorganic pattern and a partition wall may be removed, and residual moisture may be removed through a drying process. Thus, a phenomenon in which foreign substances are introduced through the moisture between the lower encapsulation inorganic pattern and the partition wall may be reduced or removed. As a result, pixel defects (dark spots, pixel shrinkage, or the like) of the display panel, which are caused by foreign substances, may be effectively reduced or removed.

Further, in the related art, an encapsulation organic film is thickened so that a thin film encapsulation layer has a low dielectric constant. However, in the present disclosure, an inner area is defined in a common inorganic film, and thus the common inorganic film may have a low dielectric constant close to 1. Thus, a thickness of the encapsulation organic film of the present disclosure may be reduced, and the touch sensitivity can be improved by reducing the thickness of the encapsulation organic film.

Although the description has been made above with reference to an embodiment of the present disclosure, it may be understood that those skilled in the art or those having ordinary knowledge in the art may variously modify and change the present disclosure without departing from the technical scope of the present disclosure described in the appended claims. Thus, the technical scope of the present disclosure is not limited to the detailed description of the specification, but should be defined by the appended claims.

## Claims

1. A display panel comprising:
a base layer;
a pixel defining film disposed on the base layer and defining a light emitting opening therein;
a partition wall disposed on the pixel defining film and defining a partition wall opening therein overlapping the light emitting opening in a plan view;
a plurality of light emitting elements each including an anode, a light emitting pattern, and a cathode and arranged inside the light emitting opening and the partition wall opening, wherein the cathode is in contact with the partition wall;
a plurality of lower encapsulation inorganic patterns configured to cover the plurality of light emitting elements, respectively; and
a common inorganic film configured to cover the plurality of lower encapsulation inorganic patterns and fill spaces between the partition wall and the plurality of lower encapsulation inorganic patterns.

2. The display panel of claim 1, wherein the plurality of light emitting elements include first light emitting elements, second light emitting elements, and third light emitting elements configured to emit different color lights, and
the plurality of lower encapsulation inorganic patterns includes first lower encapsulation inorganic patterns configured to cover the first light emitting elements, second lower encapsulation inorganic patterns configured to cover the second light emitting elements, and third lower encapsulation inorganic patterns configured to cover the third light emitting elements.

3. The display panel of claim 2, wherein the common inorganic film covers the first to third lower encapsulation inorganic patterns, which are dried.

4. The display panel of claim 3, further comprising:
first additional encapsulation inorganic patterns configured to cover the dried first lower encapsulation inorganic patterns;
second additional encapsulation inorganic patterns configured to cover the dried second lower encapsulation inorganic patterns; and
third additional encapsulation inorganic patterns configured to cover the dried third lower encapsulation inorganic patterns.

5. The display panel of claim 4, wherein the common inorganic film covers the first to third additional encapsulation inorganic patterns.

6. The display panel of any one of claims 1 to 5, wherein an inner area is defined in the common inorganic film, and the inner area is empty space.

7. The display panel of claim 6, wherein:
(i) the inner area has a shape surrounding the light emitting opening in the plan view; and/or
(ii) a portion of the inner area overlaps the plurality of lower encapsulation inorganic patterns in the plan view.

8. The display panel of any one of claims 1 to 7, wherein each of the plurality of lower encapsulation inorganic patterns includes:
an upper surface;
first side surfaces extending from the upper surface in a thickness direction of the base layer;
lower surfaces extending from the first side surfaces toward a center of the anode in a cross-sectional view; and
second side surfaces extending from the lower surfaces in the thickness direction of the base layer, optionally wherein the common inorganic film covers the upper surface, the first side surfaces, the lower surfaces, and the second side surfaces of each of the plurality of lower encapsulation inorganic patterns, which are dried.

9. The display panel of any one of claims 1 to 8, wherein the common inorganic film includes an inorganic material.

10. The display panel of any one of claims 1 to 10, wherein:
(i) the common inorganic film includes at least one of a silicon nitride (SiNₓ) and a silicon oxy nitride (SiON); and/or
(ii) the display panel further comprises:
an encapsulation organic film configured to cover the common inorganic film; and
an upper encapsulation inorganic film configured to cover the encapsulation organic film.

11. A method of manufacturing a display panel, the method comprising:
providing a preliminary display panel including a base layer, a pixel defining film disposed on the base layer, and a preliminary partition wall disposed on the pixel defining film;
forming a partition wall defining a partition wall opening therein from the preliminary partition wall;
etching the pixel defining film to form a light emitting opening overlapping the partition wall opening in a plan view;
forming a light emitting element and a lower encapsulation inorganic pattern configured to cover the light emitting element inside the light emitting opening and the partition wall opening; and
drying outer surfaces of the partition wall and the lower encapsulation inorganic pattern.

12. The method of claim 11, wherein the forming of the light emitting element and the lower encapsulation inorganic pattern includes:
forming a first light emitting element and a first lower encapsulation inorganic pattern configured to cover the first light emitting element;
forming a second light emitting element and a second lower encapsulation inorganic pattern configured to cover the second light emitting element; and
forming a third light emitting element and a third lower encapsulation inorganic pattern configured to cover the third light emitting element.

13. The method of claim 12, further comprising:
forming a common inorganic film configured to cover the first to third lower encapsulation inorganic patterns.

14. The method of claim 12, further comprising:
forming an additional encapsulation inorganic pattern configured to cover the lower encapsulation inorganic pattern.

15. The method of claim 14, wherein the drying of the outer surfaces of the partition wall and the lower encapsulation inorganic pattern includes:
drying the outer surface of the partition wall and an outer surface of the first lower encapsulation inorganic pattern after the forming of the first light emitting element and the first lower encapsulation inorganic pattern;
drying the outer surface of the partition wall and an outer surface of the second lower encapsulation inorganic pattern after the forming of the second light emitting element and the second lower encapsulation inorganic pattern; and
drying the outer surface of the partition wall and an outer surface of the third lower encapsulation inorganic pattern after the forming of the third light emitting element and the third lower encapsulation inorganic pattern, and
wherein the forming of the additional encapsulation inorganic pattern includes:
forming a first additional encapsulation inorganic pattern configured to cover the first lower encapsulation inorganic pattern;
forming a second additional encapsulation inorganic pattern configured to cover the second lower encapsulation inorganic pattern; and
forming a third additional encapsulation inorganic pattern configured to cover the third lower encapsulation inorganic pattern, optionally further comprising:
forming a common inorganic film configured to cover the first to third additional encapsulation inorganic patterns.
